# EUROPEAN PATENT SPECIFICATION

(11) **EP 4 142 164 B1**
(45) Date of publication and mention of the grant of the patent: **18.03.2026**
(21) Application number: 21812262.0
(22) Date of filing: 25.04.2021
(51) Int. Cl.: H04B 1/40, H04B 1/00, H04B 1/04

(54) **RADIO FREQUENCY PA MID DEVICE, RADIO FREQUENCY TRANSCEIVING SYSTEM, AND COMMUNICATION DEVICE**
HOCHFREQUENZ-PA-MID-VORRICHTUNG, HOCHFREQUENZ-SENDEEMPFANGSSYSTEM UND KOMMUNIKATIONSVORRICHTUNG
DISPOSITIF INTERMÉDIAIRE AMPLIFICATEUR DE PUISSANCE DE RADIOFRÉQUENCE, SYSTÈME D'ÉMISSION-RÉCEPTION RADIOFRÉQUENCE ET DISPOSITIF DE COMMUNICATION

(30) Priority: 26.05.2020 CN 202010455914; 26.05.2020 CN 202020906935 U
(43) Date of publication of application: 01.03.2023
(73) Proprietor: GUANGDONG OPPO MOBILE TELECOMMUNICATIONS CORP., LTD., Dongguan, Guangdong 523860 (CN)
(72) Inventor: CHEN, Wu, Dongguan, Guangdong 523860 (CN)
(74) Representative: Taor, Simon Edward William
(86) International application number: PCT/CN2021/089495
(87) International publication number: WO 2021/238534

(56) References cited:
- EP-A1- 3 599 724
- EP-A1- 3 820 124
- CN-A- 106 506 036
- CN-A- 106 921 405
- CN-A- 108 900 234
- CN-A- 108 988 877
- CN-A- 108 988 903
- CN-U- 212 588 326
- CN-U- 212 588 327
- CN-U- 212 811 690
- US-A1- 2015 091 776
- US-A1- 2019 190 548

## Description

### CROSS-REFERENCE TO RELATED APPLICATIONS

This application claims priorities to Chinese Patent Applications No. 202010455914.2 and No. 202020906935.7, entitled "RADIO FREQUENCY PA MID DEVICE, RADIO FREQUENCY TRANSCEIVING SYSTEM, AND COMMUNICATION APPARATUS", filed with China National Intellectual Property Administration on May 26, 2020.

### FIELD

The present disclosure relates to the field of radio-frequency technologies, and more particularly, to a radio-frequency Power Amplifier Modules including Duplexers (PA Mid) device, a radio-frequency transceiving system, and a communication apparatus.

### BACKGROUND

The statements here provide only background information relevant to the present disclosure and do not necessarily constitute example related art.

With the development and advancement of technology, 5-th generation (5G) mobile communication technology has been increasingly applied to electronic devices. 5G mobile communication technology has a higher communication frequency than 4G mobile communication technology. Generally, in order to support polling transmission of a radio-frequency signal among multiple antennas, a plurality of discrete switches is required to be disposed in transmitting paths of a radio-frequency system to support polling transmission of a radio-frequency signal among a plurality of antennas, thereby leading to higher cost and occupying a relatively large area of a substrate. EP3599724A1 discloses a radio frequency system, the system supports a simultaneous downlink reception with four antennas and includes m antennas, a radio frequency processing circuit, and a radio frequency transceiver coupled with the radio frequency processing circuit.

### SUMMARY

According to embodiments of the present disclosure, a radio-frequency PA Mid device, a radio-frequency transceiving system, and a communication apparatus are provided. The invention is set out in the appended set of claims.

In the above-mentioned radio-frequency PA Mid device, radio-frequency transceiving system, and communication apparatus, the power amplifier, the first filtering unit, and the multi-channel selection switch in the radio-frequency PA Mid device are all integrated and packaged in the same chip, thereby increasing an integration level of the radio-frequency PA Mid device, while reducing the costs and an area of a substrate occupied by various components in a radio-frequency system. By integrating the multi-channel selection switch into the radio-frequency PA Mid device, an area of at least 10 mm² can be saved, when compared with the case that the multi-channel selection switch is disposed outside the radio-frequency PA Mid device. In this way, more space can be saved for performance optimization of other modules. Further, the radio-frequency PA Mid device integrated with the multi-channel selection switch has the same as the radio-frequency PA Mid device without the multi-channel selection switch. That is, the size of the radio-frequency PA Mid device is unchanged by integrating the multi-channel selection switch into the radio-frequency PA Mid device 10.

One or more of the embodiments of the present disclosure are described in detail below in combination with the accompanying drawings. Other features, objects and advantages of the present disclosure will become apparent from the specification, the accompanying drawings, and the claims as attached.

### BRIEF DESCRIPTION OF DRAWINGS

In order to clearly explain technical solutions of embodiments of the present disclosure or in the related art, drawings used in description of the embodiments or the related art will be briefly described below. The drawings described below merely illustrate some embodiments of the present disclosure. Based on these drawings, other drawings can be obtained by those skilled in the art without paying creative efforts.
FIG. 1 is a first schematic structural diagram of a radio-frequency PA Mid device
FIG. 2 is a second schematic structural diagram of a radio-frequency PA Mid device
FIG. 3 is a third schematic structural diagram of a radio-frequency PA Mid device according to an embodiment of the present disclosure.
FIG. 4A is a fourth schematic structural diagram of a radio-frequency PA Mid device
FIG. 4B is a fifth schematic structural diagram of a radio-frequency PA Mid device according to an embodiment of the present disclosure.
FIG. 5A is a sixth schematic structural diagram of a radio-frequency PA Mid device according to an embodiment of the present disclosure.
FIG. 5B is a seventh schematic structural diagram of a radio-frequency PA Mid device
FIG. 5C is an eighth schematic structural diagram of a radio-frequency PA Mid device
FIG. 5D is a ninth schematic structural diagram of a radio-frequency PA Mid device according to an embodiment of the present disclosure.
FIG. 6A is a first schematic diagram of a pin configuration of a radio-frequency PA Mid device according to an embodiment of the present disclosure.
FIG. 6B is a schematic diagram of a packaging structure of a radio-frequency PA Mid device in FIG. 6A.
FIG. 6C is a second schematic diagram of a pin configuration of a radio-frequency PA Mid device
FIG. 6D is a schematic diagram of a packaging structure of a radio-frequency PA Mid device in FIG. 6C.
FIG. 7A is a third schematic diagram of a pin configuration of a radio-frequency PA Mid device
FIG. 7B is a schematic diagram of a packaging structure of a radio-frequency PA Mid device in FIG. 7A.
FIG. 7C is a fourth schematic diagram of a pin configuration of a radio-frequency PA Mid device
FIG. 7D is a schematic diagram of a packaging structure of a radio-frequency PA Mid device in FIG. 7C.
FIG. 8 is a first schematic structural diagram of a radio-frequency transceiving system according to an embodiment of the present disclosure.
FIG. 9 is a first schematic structural diagram of a radio-frequency L-DRX module according to an embodiment of the present disclosure.
FIG. 10A is a second schematic structural diagram of a radio-frequency L-DRX module according to an embodiment of the present disclosure.
FIG. 10B is a third schematic structural diagram of a radio-frequency L-DRX module according to an embodiment of the present disclosure.
FIG. 11A is a fourth schematic structural diagram of a radio-frequency L-DRX module according to an embodiment of the present disclosure.
FIG. 11B is a fifth schematic structural diagram of a radio-frequency L-DRX module according to an embodiment of the present disclosure.
FIG. 12A is a first schematic diagram of an application scenario for a feedback channel information transmission of a communication apparatus according to an embodiment.
FIG. 12B is a second schematic diagram of an application scenario for a feedback channel information transmission of a communication apparatus according to an embodiment.
FIG. 13 is a schematic structural diagram of a mode of antenna polling transmission of SRS according to an embodiment.
FIG. 14A is a second schematic structural diagram of a radio-frequency transceiving system
FIG. 14B is a third schematic structural diagram of a radio-frequency transceiving system according to an embodiment of the present disclosure.
FIG. 15A is a fourth schematic structural diagram of a radio-frequency transceiving system
FIG. 15B is a fifth schematic structural diagram of a radio-frequency transceiving system
FIG. 16A is a sixth schematic structural diagram of a radio-frequency transceiving system according to an embodiment of the present disclosure.
FIG. 16B is a seventh schematic structural diagram of a radio-frequency transceiving system according to an embodiment of the present disclosure.
FIG. 17 is a schematic structural diagram of a communication apparatus according to an embodiment of the present disclosure.

### DESCRIPTION OF EMBODIMENTS

In order to facilitate understanding of the present disclosure and to clarify the above-mentioned objects, features, and advantages of the present disclosure, specific embodiments of the present disclosure are described in detail below in conjunction with the accompanying drawings. In the following description, many specific details are provided to facilitate full understanding of the present disclosure. Preferred embodiments of the present disclosure are illustrated by means of the accompanying drawings. However, the present disclosure can be implemented in various forms and is not limited to the embodiments described herein. On the contrary, these embodiments are merely provided to facilitate thorough and comprehensive understanding of the content of the present disclosure. The present disclosure can be implemented in various manners other than those described herein, and similar improvements can be made by those skilled in the art without contradicting the intent of the present disclosure. Therefore, the present disclosure is not limited by specific embodiments disclosed below.

In addition, the term "first" or "second" is only for descriptive purposes, and it cannot be indicating or implying relative importance or implicitly indicating the number of indicated technical features. Therefore, the features defined with "first" or "second" can explicitly or implicitly include at least one of the features. In the description of the present disclosure, "plurality of" means at least two, unless otherwise specifically indicated. In the present disclosure, "a number of" means at least one, unless otherwise specifically indicated.

A radio-frequency transceiving system involved in the embodiments of the present disclosure can be applied to a communication apparatus having wireless communication capabilities. The communication apparatus may be a handheld apparatus, a vehicle-mounted apparatus, a wearable apparatus, a computing apparatus, any other processing apparatuses connected to a wireless modem, a user equipment (UE) in various forms (e.g., a mobile phone), or a mobile station (MS), etc. For ease of description, the above-mentioned apparatuses can be collectively referred to as the communication apparatus. A network device may include a base station, an access point, etc.

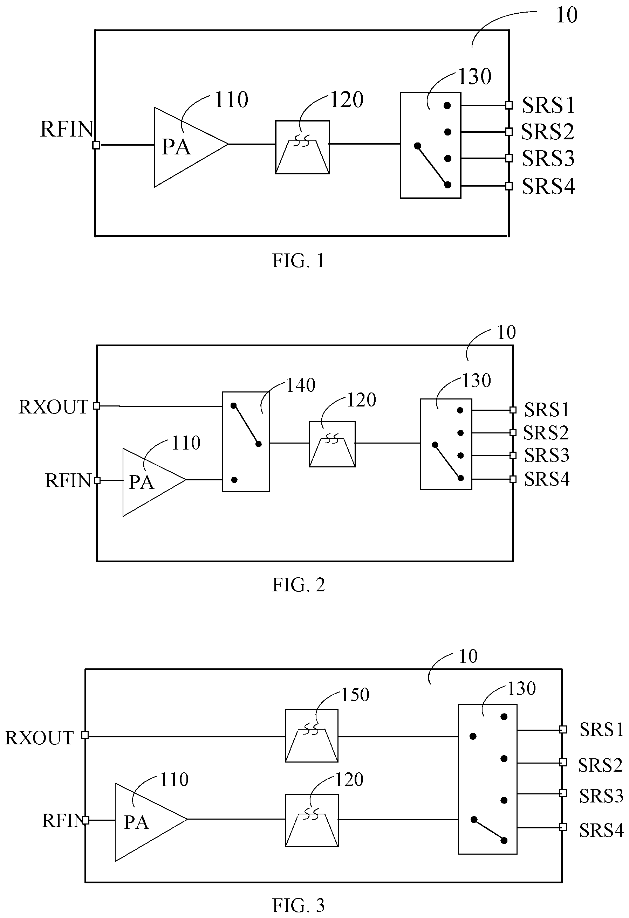

According to an embodiment of the present disclosure, a radio-frequency PA Mid device is provided. As illustrated in FIG. 1, in an embodiment, the radio-frequency PA Mid device 10 can be used to support control of polling transmission of radio-frequency signals among a plurality of antennas. As an example, a radio-frequency PA Mid device 10 has a plurality of transmitting paths for transmitting radio-frequency signals, to support a function of polling transmission of SRS among a plurality of antenna ports.

In an embodiment, the radio-frequency signal may be a 5G signal, such as a 5G signal in an N41 frequency band, a radio-frequency signal in an N77 frequency band, a radio-frequency signal in an N78 frequency band, a radio-frequency signal in an N79 frequency band, etc. As an example, an operating frequency band of N41 ranges from 496 MHz to 2,690 MHz; an operating frequency band of N77 ranges from 3.3 GHz to 4.2 GHz; an operating frequency band of N78 ranges from 3.3 GHz to 3.8 GHz; and an operating frequency band of N79 ranges from 4.4 GHz to 5.0 GHz. It should be noted that the operating frequency band of N77 covers the operating frequency band of N78. That is, when the radio-frequency PA Mid device 10 can support a transceiving of radio-frequency signals in the N77 frequency band, it can also support a transceiving of radio-frequency signals in the N78 frequency band. It should be noted that the radio-frequency signals may also be Long-Term Evolution (LTE) signals, Wireless Fidelity (WiFi) signals, etc. In the embodiments of the present disclosure, the operating frequency band of the radio-frequency signals is not further limited.

In an embodiment, the radio-frequency PA Mid device 10 has a transmitting port RFIN and a plurality of antenna ports SRS (e.g., SRS1, SRS2, SRS3, SRS4). The radio-frequency PA Mid device 10 can be regarded as a packaged chip. The transmitting port RFIN and the antenna ports SRS provided in the radio-frequency PA Mid device 10 can be regarded as radio-frequency pin terminals of the radio-frequency PA Mid device 10 for connecting to various external devices. As an example, the transmitting port RFIN may be used configured to connect to a radio-frequency transceiver. The plurality of antenna ports SRS may be used configured to connect to antennas.

In an embodiment, the radio-frequency PA Mid device 10 includes a power amplifier 110, a first filtering unit 120, and a multi-channel selection switch 130. The transmitting port RFIN of the radio-frequency PA Mid device 10 is connected to the plurality of antenna ports SRS through the power amplifier 110, the first filtering unit 120, and the multi-channel selection switch 130 in sequence.

As an example, the power amplifier 110 has an input terminal connected to the transmitting port RFIN, and the power amplifier 110 is configured to perform a power amplification processing on a received radio-frequency signal inputted via a receiving port. The first filtering unit 120 is connected to an output terminal of the power amplifier 110. The first filtering unit 120 is configured to receive the radio-frequency signal processed by the power amplifier 110 and filter the received radio-frequency signal.

The multi-channel selection switch 130 includes at least one first terminal and a plurality of second terminals. One first terminal of the multi-channel selection switch 130 is connected to the first filtering unit 120. The plurality of second terminals is connected to the plurality of antenna ports SRS in a one-to-one correspondence. The multi-channel selection switch 130 is configured to selectively switch on a transmitting path between the transmitting port RFIN and any one antenna port SRS, for transmitting the radio-frequency signal and supporting a function of polling transmission of SRS among the plurality of antenna ports SRS. The number of the second terminals of the multi-channel selection switch 130 is the same as the number of the antenna ports SRS. One antenna port SRS is correspondingly connected to one second terminal of the multi-channel selection switch 130. Further, each antenna port SRS may be correspondingly connected to at least one antenna.

The following embodiments are not according to the invention and are present for illustration purposes only. For example, the radio-frequency PA Mid device 10 may have two antenna ports SRS, which can be defined as a first antenna port SRS1 and a second antenna port SRS2. The first antenna port SRS1 can be connected to a first antenna, and the second antenna port SRS2 can be connected to a second antenna. The multi-channel selection switch 130 may be a Single-Pole Double-Throw (SPDT) switch. The SPDT switch has two selection terminals connected to the first antenna port SRS1 and the second antenna port SRS2, respectively, thereby achieving the polling transmission of SRS by the first antenna and the second antenna. That is, the radio-frequency signal is inputted to the radio-frequency PA Mid device 10 via the transmitting port RFIN; the radio-frequency signal reaches the multi-channel selection switch 130 via the power amplifier 110 and the first filtering unit 120, switched to the first antenna port SRS1; and the radio-frequency signal is transmitted via the first antenna. Further, the radio-frequency signal may be switched to the second antenna port SRS2 through the multi-channel selection switch 130 and transmitted via the second antenna.

The radio-frequency PA Mid device 10 has four antenna ports SRS, which can be defined as a first antenna port SRS1, a second antenna port SRS2, a third antenna port SRS3, and a fourth antenna port SRS4. The first antenna port SRS1 can be connected to a first antenna. The second antenna port SRS2 can be connected to a second antenna. The third antenna port SRS3 can be connected to a third antenna. The fourth antenna port SRS4 can be connected to a fourth antenna. The multi-channel selection switch 130 can be a Single-Pole Four-Throw (SP4T) switch. The SP4T switch has four selection terminals connected to the first antenna port SRS1, the second antenna port SRS2, the third antenna port SRS3, and the fourth antenna port SRS4, respectively. Through switching control of the multi-channel selection switch 130, the polling transmission of SRS by the first antenna, the second antenna, the third antenna, and the fourth antenna can be realized.

In the embodiments of the present disclosure, the radio-frequency PA Mid device 10 can be regarded as a packaged chip. That is, the power amplifier 10, the first filtering unit 120, and the multi-channel selection switch 130 in the radio-frequency PA Mid device 10 are all integrated and packaged in the same chip. In this way, an integration level of the radio-frequency PA Mid device 10 can be increased, the cost thereof is lowered, while reducing an area of a substrate occupied by various components in a radio-frequency system. By integrating the multi-channel selection switch 130 into the radio-frequency PA Mid device 10, an area of at least 10 mm² can be saved, when compared with the case that the multi-channel selection switch 130 is disposed outside the radio-frequency PA Mid device 10. In this way, more space can be saved for performance optimization of other modules. Further, the radio-frequency PA Mid device 10 integrated with the multi-channel selection switch 130 has the same as the radio-frequency PA Mid device 10 without the multi-channel selection switch 130. That is, the size of the radio-frequency PA Mid device 10 is unchanged by integrating the multi-channel selection switch 130 into the radio-frequency PA Mid device 10.

In an embodiment, the first filtering unit 120 includes a band-pass filter or a low-pass filter. It should be noted that a type of the first filtering unit 120 can be selected based on the operating frequency band of the radio-frequency signal supportable by the radio-frequency PA Mid device 10. For example, when the radio-frequency signal supported by the radio-frequency PA Mid device 10 is a 5G signal in the N41 frequency band, the first filtering unit 120 of the radio-frequency PA Mid device 10 may be a low-pass filter, which only allows radio-frequency signals in the N41 frequency band to pass through and filters out spurious waves outside of the N41 frequency band; when the radio-frequency signal supported by the radio-frequency PA Mid device 10 is a 5G signal in the N77 frequency band, the first filtering unit 120 of the radio-frequency PA Mid device 10 may be a band-pass filter, which only allows radio-frequency signals in the N77 frequency band to pass through and filters out spurious waves outside of the N77 frequency band; and when the radio-frequency signal supported by the radio-frequency PA Mid device 10 is a 5G signal in the N79 frequency band, the first filtering unit 120 of the radio-frequency PA Mid device 10 may be a band-pass filter, which only allows radio-frequency signals in the N79 frequency band to pass through and filters out spurious waves outside of the N79 frequency band.

It should be noted that in the embodiments of the present disclosure, a suitable filter can be selected based on the frequency band of the radio-frequency signal, to perform a filtering processing on the radio-frequency signal.

As illustrated in FIG. 2, in an embodiment, the radio-frequency PA Mid device 10 has a receiving port RXOUT configured to connect to the radio-frequency transceiver. The radio-frequency PA Mid device 10 further includes a first switching unit 140. The first switching unit 140 has a control terminal connected to the first filtering unit 120, a first selection terminal connected to the output terminal of the power amplifier 110, and a second selection terminal connected to the receiving port RXOUT. The first switching unit 140 is configured to selectively switch on a receiving path where the receiving port RXOUT is located and the transmitting path where the transmitting port RFIN is located.

As an example, the first switching unit 140 may be a radio-frequency SPDT switch. That is, the control terminal of the radio-frequency SPDT switch is connected to a second filtering unit 320, the first selection terminal of the radio-frequency SPDT switch is connected to the receiving port RXOUT, and the second selection terminal of the radio-frequency SPDT switch is connected to the output terminal of the power amplifier 110, to selectively switch on the receiving path and the transmitting path of the radio-frequency PA Mid device 10.

In this embodiment, by means of disposing the first switching unit 140 in the radio-frequency PA Mid device 10, the radio-frequency PA Mid device 10 can be provided with the receiving path and the transmitting path, which can perform the transceiving control of the radio-frequency signal in turn. For example, the transmitting control of the radio-frequency signal can be achieved in such a manner that, the radio-frequency signal is inputted from the transmitting port RFIN, it reaches the first switching unit 140 via the power amplifier 110, it is switched to the first filtering unit 120 by the first switching unit 140 and switched to any antenna port SRS by a multi-channel switch, and the radio-frequency signal is outputted by the antenna port SRS, to achieve transmitting control of the radio-frequency signal. The receiving control of the radio-frequency signal can be achieved in such a manner that the radio-frequency signal is received by any antenna port SRS, it reaches the first filtering unit 120 via the multi-channel selection switch 130, and it is switched to the receiving port RXOUT by the first switching unit 140.

As illustrated in FIG. 3, in an embodiment, the radio-frequency PA Mid device 10 has a receiving port RXOUT configured to connect to the radio-frequency transceiver and further includes a second filtering unit 150. The multi-channel selection switch 130 is a radio-frequency Double-Pole Four-Throw (DP4T) switch including two first terminals and four second terminals. The second filtering unit 150 is connected to each of the receiving port RXOUT and another first terminal of the multi-channel selection switch 130 to form a receiving path. The second filtering unit 150 is configured to perform a filtering processing on the radio-frequency signal received by any antenna port SRS.

In an embodiment, the second filtering unit 150 includes a low-pass filter or a band-pass filter. It should be noted that a type of the second filtering unit 150 can be selected based on the operating frequency band of the radio-frequency signal supportable by the radio-frequency PA Mid device 10. For example, the type of filtering of the second filtering unit 150 may be the same as that of the first filtering unit 120, both of which can perform a filtering processing on the radio-frequency signal transmitted and received by the radio-frequency system.

In contrast to the embodiment illustrated in FIG. 3, in this embodiment, the first switching unit 140 is omitted and the second filtering unit 150 is added to form the receiving path for receiving the radio-frequency signal. It should be noted that in this embodiment, the multi-channel selection switch 130 is the radio-frequency DP4T switch and has two first terminals. One first terminal of the multi-channel selection switch 130 is connected to the receiving port RXOUT via the second filtering unit 150, and the other one first terminal of the multi-channel selection switch 130 is connected to the transmitting port RFIN via the first filtering unit 120 and the power amplifier 110.

When the multi-channel selection switch 130 is the radio-frequency SP4T switch, the values of insertion loss of the radio-frequency SP4T switch (e.g., MXD8643) are as illustrated in Table 1. In the radio-frequency system, radio-frequency cable losses for respective frequency bands are as illustrated in Table 2.

**[Table 1] Values of insertion loss of an SP4T switch**

| Frequency band (GHz) | N41 | N77 | N79 |
|---|---|---|---|
| Insertion loss (dB) | 0.65 | 0.7 | 0.8 |

**[Table 2] Values of radio-frequency cable loss of link**

| Frequency band (GHz) | N41 | N77 | N79 |
|---|---|---|---|
| Insertion loss (dB) | 2.8 | 2.9 | 2.8 |

The insertion loss on a transceiving channel is reduced by removing the first switching unit 140 inside the radio-frequency PA Mid device 10. As an example, when the first radio-frequency signal is an N41 signal and input power of the transmitting port RFIN is 28.5 dBm, output power of the antenna port SRS is 25.9 dBm, and output powers of the antenna port SRS in N77 and N79 are as illustrated in Table 3. As can be seen from Table 3, the output power of the antenna port SRS is guaranteed.

**[Table 3] Values of output power for the antenna port SRS**

| Frequency band (GHz) | N41 | N77 | N79 |
|---|---|---|---|
| Antenna port SRS power (dB) | 25.9 | 25.65 | 25.8 |

In this embodiment, the first switching unit 140 is omitted and only the multi-channel selection switch 130 is retained, which can reduce a link loss of the transceiving channel of the radio-frequency PA Mid device 10. In this way, the output power of the antenna port SRS can meet communication requirements.

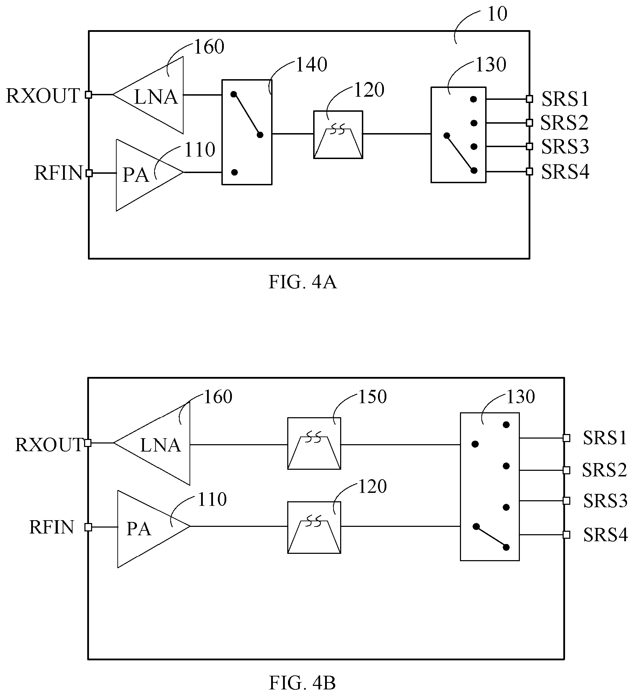

In an embodiment, as illustrated in FIG. 4A and FIG. 4B, when the radio-frequency PA Mid device 10 is used to support transceiving control of the radio-frequency signal in the N77 frequency band or the N97 frequency band, the radio-frequency PA Mid device 10 further includes a first low noise amplifier 160. The first low noise amplifier 160 is disposed in the receiving path and configured to amplify the radio-frequency signal received by any antenna port SRS. The radio-frequency signal is outputted via the receiving port RXOUT. Referring to FIG. 4A, when the radio-frequency PA Mid device 10 includes the first switching unit 140, the input terminal of the first low noise amplifier 160 is connected to a selection terminal of the first switching unit 140, and the output terminal of the first low noise amplifier 160 is connected to the receiving port RXOUT. Referring to FIG. 4B, when the radio-frequency PA Mid device 10 includes the second filtering unit 150, the input terminal of the first low noise amplifier 160 is connected to the second filtering unit 150 and the output terminal of the first low noise amplifier 160 is connected to the receiving port RXOUT.

By disposing the first low noise amplifier 160 in the receiving path of the radio-frequency PA Mid device 10, the radio-frequency signal can be amplified to meet communication requirements of the receiving path.

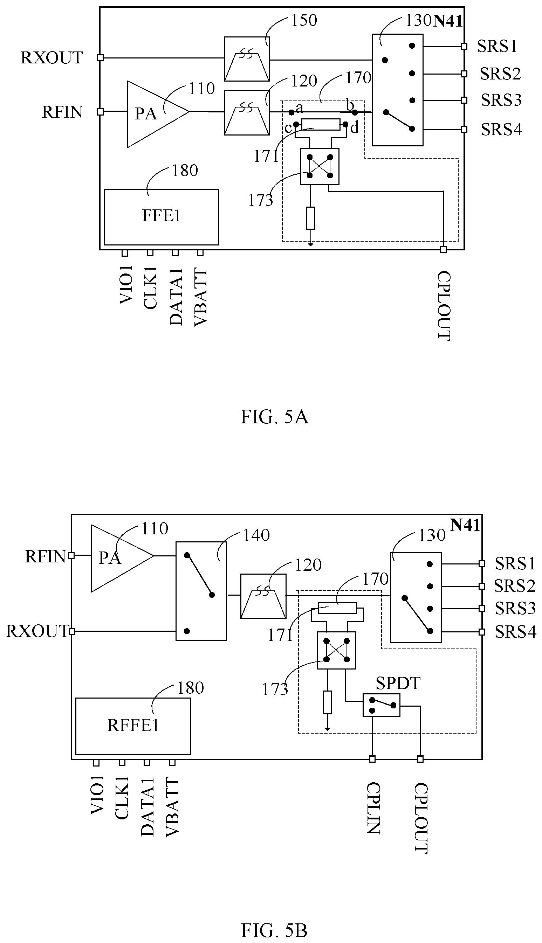

As illustrated in FIG. 5A to FIG. 5D, in an embodiment, the radio-frequency PA Mid device 10 has a coupling output port CPLOUT, and the radio-frequency PA Mid device 10 further includes a coupling circuit 170. The coupling circuit 170 is coupled to the first filtering unit 120 and the first terminal of the multi-channel selection switch 130, and the coupling circuit 170 is connected to the coupling output port CPLOUT. The coupling circuit 170 is configured to couple the radio-frequency signal to output a coupling signal for measuring power information. As an example, the coupling signal includes a forward coupling signal and a reverse coupling signal.

In an embodiment, the coupling circuit 170 includes a coupling unit 171 and a coupling switch 173. The coupling unit 171 is configured to couple the radio-frequency signal in the transmitting path to realize a coupled output of the radio-frequency signal, which can be used to measure coupling power of the radio-frequency signal. As an example, referring to FIG. 5A, the coupling unit 171 includes an input terminal a, an output terminal b, a first coupling terminal c, and a second coupling terminal d. Further, the coupling unit 171 further includes a primary line extending between the input terminal a and the output terminal b and a secondary line extending between the first coupling terminal c and the second coupling terminal d.

As an example, the input terminal a of the coupling unit 171 is coupled to the first filtering unit 120. The output terminal b of the coupling unit 171 is coupled to the first terminal of the multi-channel selection switch 130. The first coupling terminal c is configured to couple the radio-frequency signal received at the input terminal a and output a forward coupling signal. The second coupling terminal d is configured to couple a reflected signal of the radio-frequency signal received at the output terminal b and output a reverse coupling signal. Forward power information of the radio-frequency signal can be detected based on the forward coupling signal outputted at the first coupling terminal c. Correspondingly, reverse power information of the radio-frequency signal can be detected based on the reverse coupling signal outputted at the second coupling terminal d. Such a detection mode is defined as a reverse power detection mode.

The coupling switch 173 is connected to the first coupling terminal c, the second coupling terminal d, and the coupling output port CPLOUT. The coupling switch 173 is configured to selectively switch on a first coupling path between the first coupling terminal c and the coupling output port CPLOUT to detect forward power of the radio-frequency signal, in which case such a detection mode is defined as a forward power detection mode; or the coupling switch 173 is configured to selectively switch on a second coupling path between the second coupling terminal d and the coupling output port CPLOUT to detect reverse power of the radio-frequency signal, in which case such a detection mode is defined as the reverse power detection mode. That is, the coupling switch 173 is configured to switch between the forward power detection mode and the reverse power detection mode. As an example, the coupling unit 171 includes two directional couplers connected in reverse series.

In this embodiment, the radio-frequency PA Mid device 10 only has one coupling output port CPLOUT, which can meet the communication requirements. In addition, by providing only one coupling output port CPLOUT, the complexity of radio-frequency wirings inside the radio-frequency PA Mid device 10 can be reduced, thereby improving isolation performance of the respective wirings of the radio-frequency PA Mid device 10.

In an embodiment, with reference to FIG. 5B, the radio-frequency PA Mid device 10 may further have a coupling input port CPLIN for receiving coupling signals from other radio-frequency PA Mid devices 10.

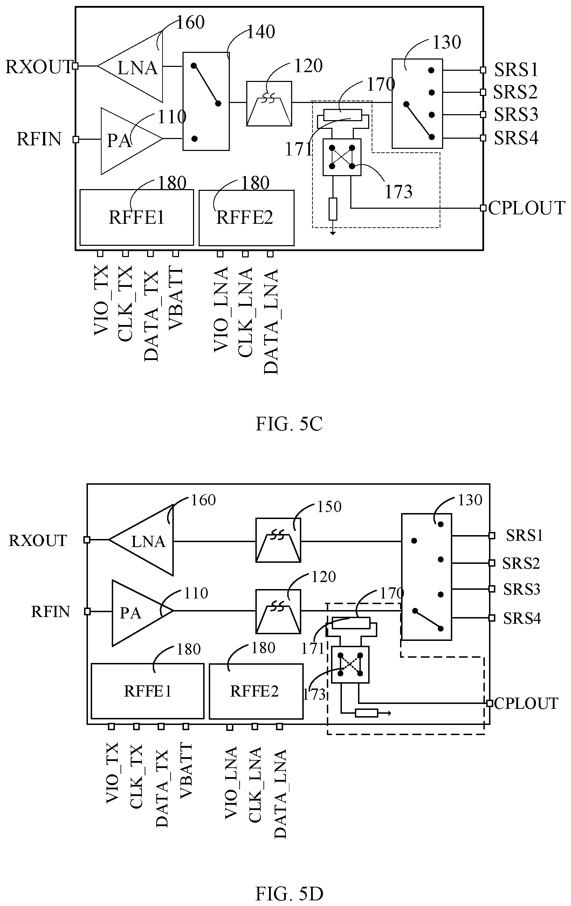

In an embodiment, the radio-frequency PA Mid device 10 further includes at least one control unit 180. Referring to FIG. 5A and FIG. 5B, when the radio-frequency PA Mid device 10 supports the transceiving control of radio-frequency signals in the N41 frequency band, the radio-frequency PA Mid device 10 includes one control unit 180. The control unit 180 is connected to the power amplifier 110, the first switching unit 140, and the coupling switch 173. The control unit 180 is configured to control a gain coefficient of the power amplifier 110 and control selective switching-on states of the first switching unit 140 and the coupling switch 173. Referring to FIG. 5C and FIG. 5D, when the radio-frequency PA Mid device 10 supports transceiving control of radio-frequency signals in the N77 or N79 frequency band, an additional control unit 180 connected to the second low noise amplifier 350 may be provided. The additional control unit 180 is configured to adjust a gain coefficient of the first low noise amplifier 160 to adjust an insertion loss of a receiving link in the radio-frequency PA Mid device 10. Thus, the sensitivity of its radio-frequency system can be improved.

In an embodiment, the control unit 180 may be a Radio Frequency Front End Control Interface (RFFE) control unit 180. When the control unit 180 is the RFFE control unit 180, its radio-frequency PA Mid device 10 further has an input pin CLK for clock signals, an input or bidirectional pin SDATAS for single/bidirectional data signals, a reference voltage pin VIO, etc. For example, the RFFE control unit 180 may output clock and data signals to corresponding pins of the first switching unit 140 and the coupling switch 173 for on/off control of the transceiving path or the coupling path. The Mobile Industry Processor Interface (MIPI)-RFFE control unit 180 may output clock and data signals to the first low noise amplifier 160 to achieve gain adjustment control of the first low noise amplifier 130, or it may output the clock and data signals to the power amplifier 110 to control an operating state of the power amplifier 110.

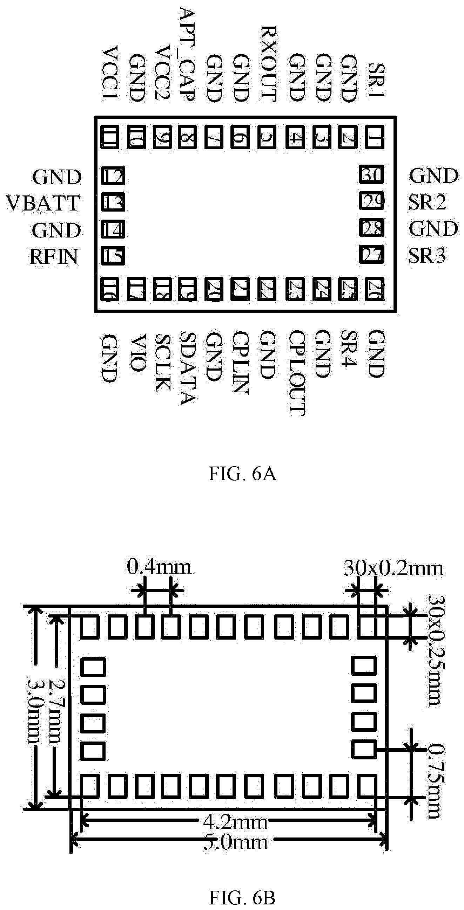

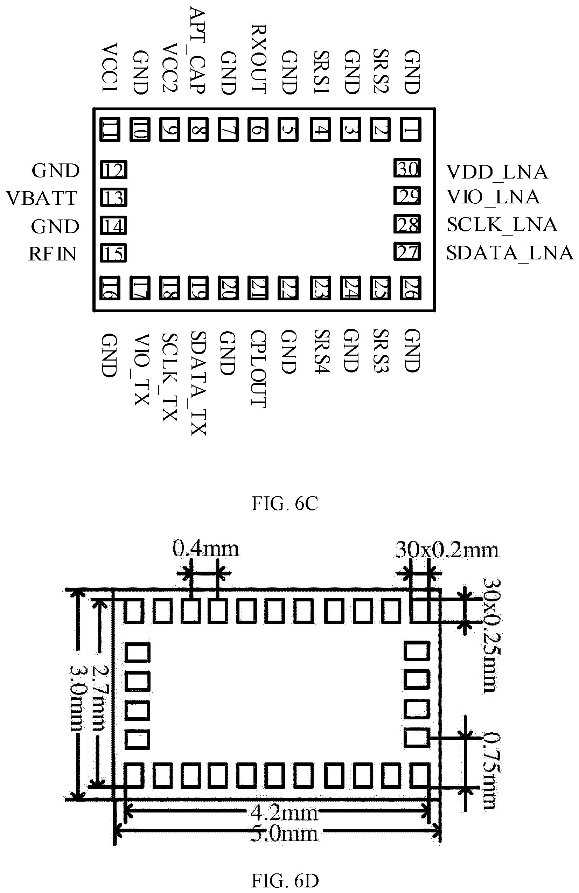

In an embodiment, each component included in the radio-frequency PA Mid device 10 may be integrated in the same chip through a packaging process. That is, the radio-frequency PA Mid device 10 may be regarded as a packaged chip. When the first switching unit 140 is integrated in the radio-frequency PA Mid device 10 and the radio-frequency PA Mid device 10 supports radio-frequency transceiving of signals in the N41 frequency band, the radio-frequency PA Mid device 10 has a pin configuration as illustrated in FIG. 6A. The respective pins in this chip correspond to the plurality of ports provided in the radio-frequency PA Mid device 10 in a one-to-one correspondence. Through packaging integration, the radio-frequency PA Mid device 10 has a package structure as illustrated in FIG. 6B, which can improve the integration level of the radio-frequency PA Mid device 10. Accordingly, when the radio-frequency PA Mid device 10 supports the radio-frequency transceiving of signals in the N77 or N79 frequency band, the radio-frequency PA Mid device 10 has a pin configuration as illustrated in FIG. 6C and a package structure as illustrated in FIG. 6D.

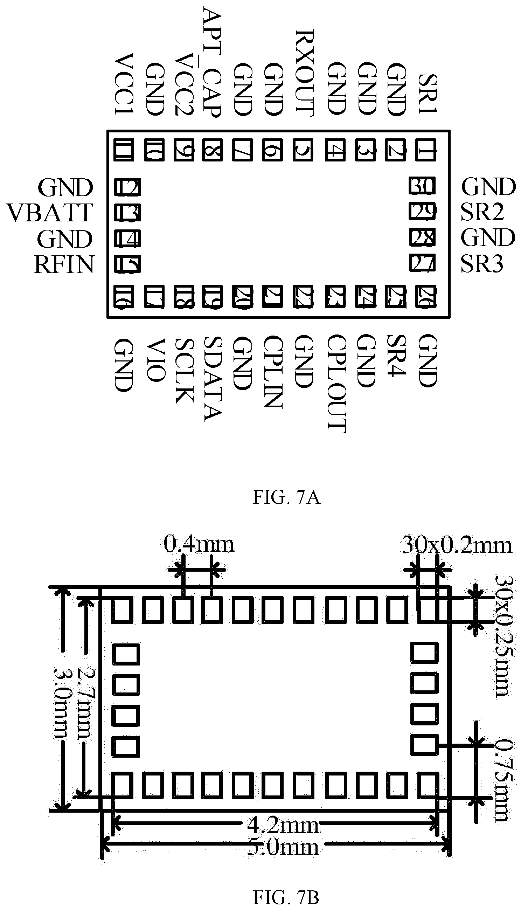

In an embodiment, when the second filtering unit 150 is integrated in the radio-frequency PA Mid device 10 and the radio-frequency PA Mid device 10 supports the radio-frequency transceiving in the N41 frequency band, the radio-frequency PA Mid device 10 has a pin configuration as illustrated in FIG. 7A. The respective pins in this chip correspond to the plurality of ports provided in the radio-frequency PA Mid device 10 in a one-to-one correspondence. Through packaging integration, the radio-frequency PA Mid device 10 has a package structure as illustrated in FIG. 7B, which can improve the integration level of the radio-frequency PA Mid device 10.

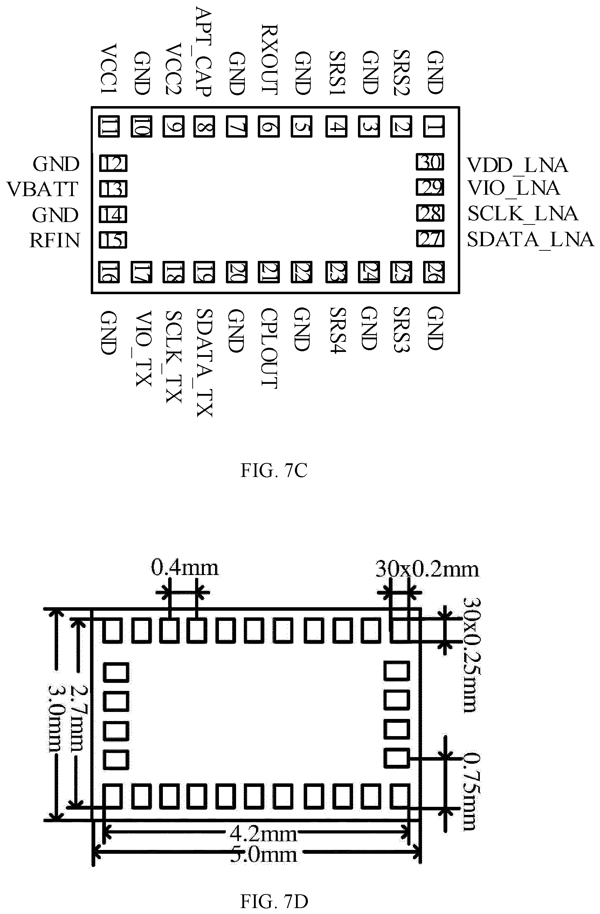

It should be noted that according to an embodiment of the present disclosure, the radio-frequency PA Mid device 10 can support the transmitting control or transceiving control of 5G signals in the N41, N77, N79 frequency bands, etc. Accordingly, when the radio-frequency PA Mid device 10 supports the radio-frequency transceiving of signals in the N77 or N79 frequency band, the radio-frequency PA Mid device 10 has a pin configuration as illustrated in FIG. 7C and a package structure as illustrated in FIG. 7D.

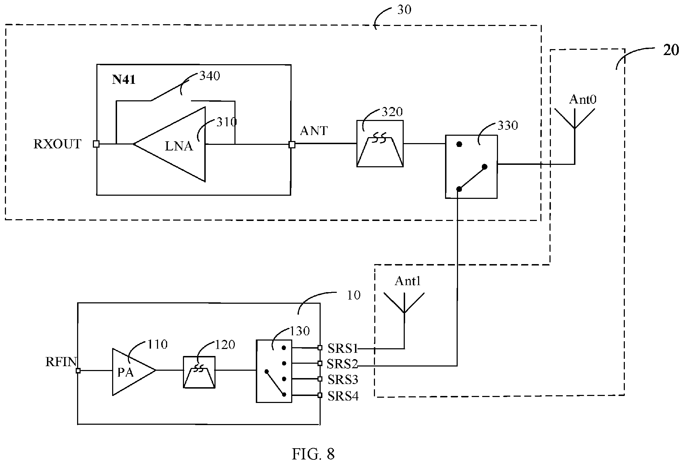

According to an embodiment of the present disclosure, a radio-frequency transceiving system is further provided. As illustrated in FIG. 8, in an embodiment, the radio-frequency transceiving system includes an antenna group 20, a radio-frequency L-DRX module 30, and the radio-frequency PA Mid device 10 according to any of the above embodiments.

In an embodiment, the antenna assembly 20 at least includes a first antenna Ant0 and a second antenna Ant1. The first antenna Ant0 and the second antenna Ant1 can both support the radio-frequency signals in different operating frequency bands, e.g., LTE signals, WiFi signals, 5G New Radio (NR) signals, etc. The first antenna Ant0 can be configured to receive and transmit (i.e., transceive) radio-frequency signals in different frequency bands. The second antenna Ant1 can be configured to transceive radio-frequency signals in different frequency bands.

In an embodiment, the first antenna Ant0 and the second antenna Ant1 may be directional or non-directional antennas. For example, the first antenna Ant0 and the second antenna Ant1 may be formed by any suitable type of antenna. For example, the first antenna Ant0 and the second antenna Ant1 may include an antenna having a resonant element and formed by at least one of the following antenna structures: an array antenna structure, a loop antenna structure, a patch antenna structure, a slot antenna structure, a spiral antenna structure, a strip antenna, a monopole antenna, a dipole antenna, or the like. Different types of antennas can be used for combinations of frequency bands of different radio-frequency signals.

The antenna assembly 20 further includes a third antenna and a fourth antenna. In the embodiments of the present disclosure, the number and type of antennas included in the antenna assembly 20 are not limited and can be determined as desired.

The radio-frequency L-DRX module 30 is connected to the first antenna Ant0 and one antenna port SRS of the radio-frequency PA Mid device 10. The radio-frequency L-DRX module 30 is configured to receive the radio-frequency signal inputted by the first antenna Ant0 and transmit the radio-frequency signal outputted by the one antenna port SRS of the radio-frequency PA Mid device 10 to the first antenna Ant0, by which the radio-frequency signal is transmitted. That is, the radio-frequency L-DRX module 30 may selectively switch on another receiving path in the radio-frequency system where the radio-frequency L-DRX module 30 is located to receive the radio-frequency signal inputted from the first antenna Ant0.

One antenna port SRS of the radio-frequency PA Mid device 10 is connected to the second antenna Ant1, and another antenna port SRS thereof is connected to the radio-frequency L-DRX module 30, to support a function of polling transmission of SRS between the first antenna Ant0 and the second antenna Ant1. The radio-frequency L-DRX module 30 can also switch on another transmitting path in the radio-frequency system where the radio-frequency PA Mid device 10 is located, and thus the radio-frequency signal outputted from one antenna port SRS of the radio-frequency PA Mid device 10 can be outputted via the second antenna Ant1.

In the radio-frequency system according to the above embodiments, the multi-channel selection switch 130 integrated in the radio-frequency PA Mid device 10, in combination with the radio-frequency L-DRX module 30, can realize the polling transmission of the radio-frequency signal between the first antenna Ant0 and the second antenna Ant1 without providing a plurality of independent cascade switches. In this way, the costs can be lowered, and an area of the substrate occupied by different components in the radio-frequency system can be reduced.

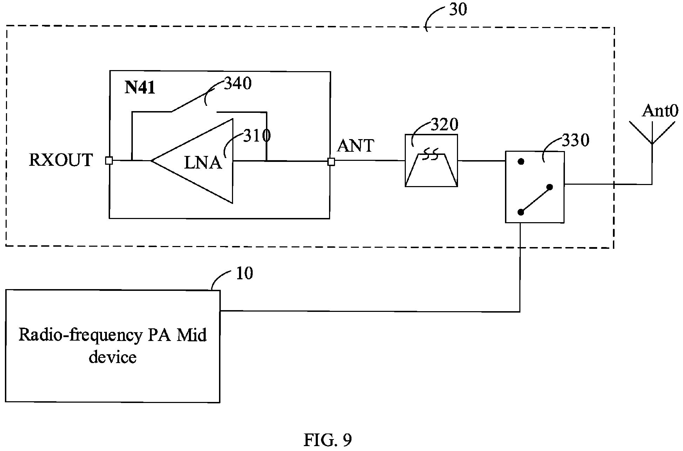

As illustrated in FIG. 9, in an embodiment, the radio-frequency L-DRX module 30 includes a second low noise amplifier 310, a third filtering unit 320, and a third switching unit 330. The second low noise amplifier 310 has an input terminal connected to the third filtering unit 320. The second low noise amplifier 310 is configured to amplify the received radio-frequency signal and output, via an output terminal thereof, the amplified radio-frequency signal to the radio-frequency transceiver. The third filtering unit 320 is connected to the third switching unit 330 and configured to perform a filtering processing on the radio-frequency signal received by the first antenna Ant0. The third switching unit 330 is connected to the first antenna Ant0 and one antenna port SRS of the radio-frequency PA Mid device 10. The third switching unit 330 is configured to selectively switch on a receiving path where the second low noise amplifier 310 is located and a transmitting path where the radio-frequency PA Mid device 10 is located.

In an embodiment, the third switching unit 330 may be the radio-frequency SPDT switch. That is, the radio-frequency SPDT switch has the control terminal connected to the first antenna Ant0, the first selection terminal connected to the third filtering unit 320, and the second selection terminal connected to one antenna port SRS of the radio-frequency PA Mid device 10, to selectively switch on the receiving path where the second low noise amplifier 310 is located and the transmitting path where the radio-frequency PA Mid device 10 is located.

Referring to FIG. 9, in an embodiment, when the radio-frequency L-DRX module 30 is configured to support radio-frequency signals in the N41 frequency band, the radio-frequency L-DRX module 30 further includes a bypass switch 340 in parallel with the second low noise amplifier 310. When the radio-frequency system receives radio-frequency signals received by the plurality of antennas, the bypass switch 340 may be controlled to be turned off in the event of a large blocking signal to prevent the radio-frequency signal from being received at too high power to saturate the RF transceiver.

In an embodiment, referring to FIG. 9, the second low noise amplifier 310 and the bypass switch 340 are packaged in the same chip. When the second low noise amplifier 310 and the bypass switch 340 are packaged in the same chip, the chip may be regarded as a Low Noise Amplifier (LNA) device having the radio-frequency receiving port RXOUT and the radio-frequency antenna port ANT. The input terminal of the second low noise amplifier 310 is connected to the radio-frequency antenna port ANT. The output terminal of the second low noise amplifier 310 is connected to the radio-frequency receiving port RXOUT. The integration level of the LNA device can be improved by packaging the second low noise amplifier 310 and the bypass switch 340 in the same chip.

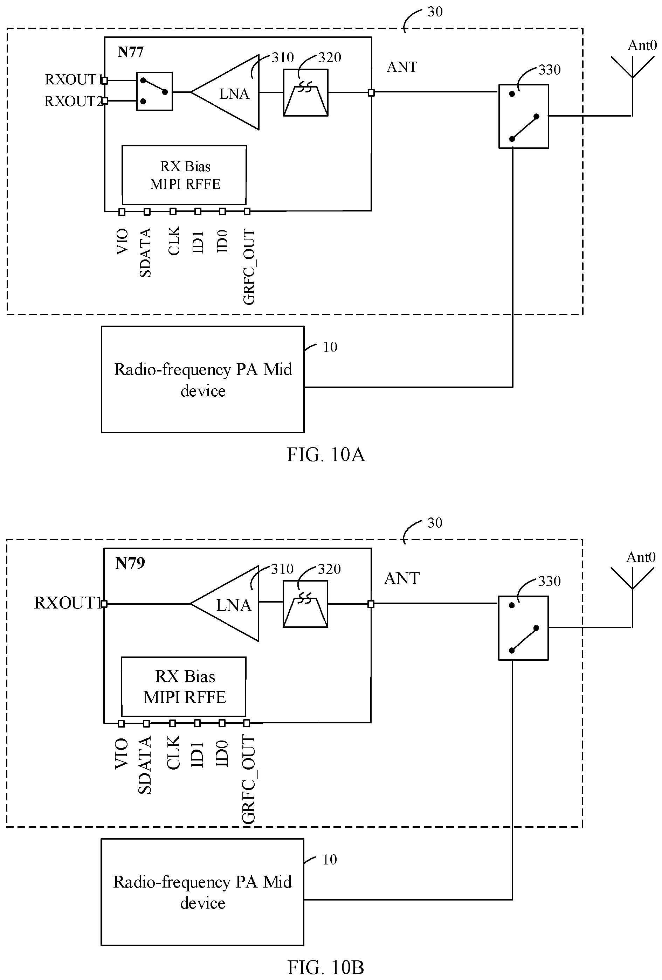

As illustrated in FIG. 10A and FIG. 10B, in an embodiment, when the radio-frequency L-DRX module 30 is configured to support radio-frequency signals in the N77 and N79 frequency bands, the second low noise amplifier 310 and the third filtering unit 320 are packaged in the same chip. The packaged chip is regarded as the LNA device. The third switching unit 330 and the LNA device are two discrete devices.

As in the previous embodiments, the LNA device further has the radio-frequency antenna port ANT and the radio-frequency receiving port RXOUT. The radio-frequency antenna port ANT is connected to the radio-frequency receiving port RXOUT via the third filtering unit 320 and the second low noise amplifier 310. Further, the LNA device is further integrated with a control unit 180 configured to control the second low noise amplifier 310, to adjust the gain coefficient of the low noise amplifier. Therefore, a receiving power of the radio-frequency signal at the radio-frequency receiving port RXOUT can be adjusted.

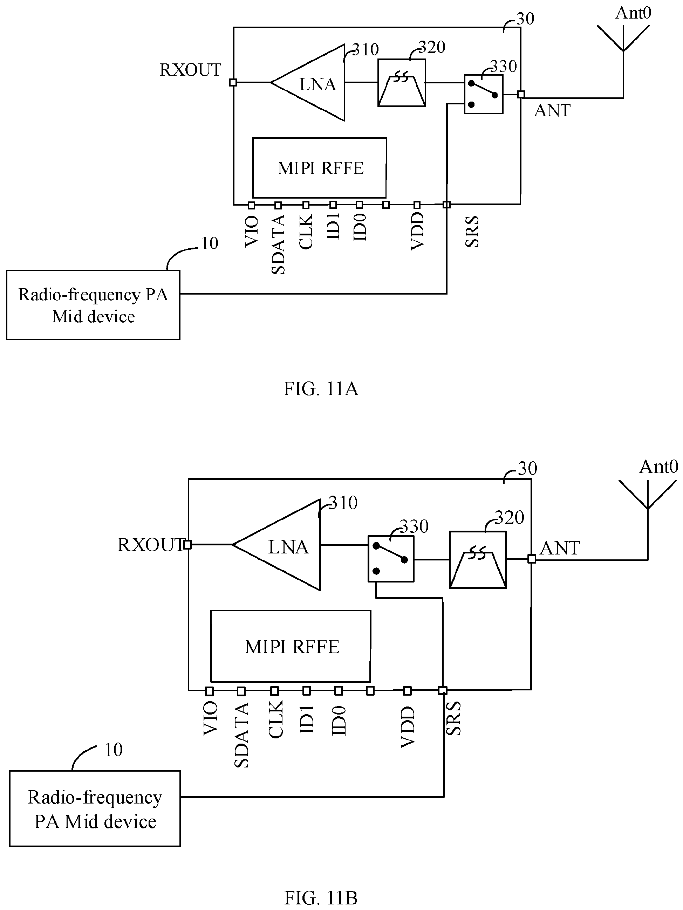

As illustrated in FIG. 11A, in an embodiment, the second low noise amplifier 310, the third filtering unit 320, and the third switching unit 330 are all packaged in the same chip. The packaged chip serves as the LNA device. As an example, the LNA device can have the radio-frequency receiving port RXOUT, the radio-frequency transmitting port SRS, and the radio-frequency antenna port ANT. The control terminal of the third switching unit 330 is connected to the radio-frequency antenna port ANT. One selection terminal of the third switching unit 330 is connected to the third filtering unit 320. Another selection terminal of the third switching unit 330 is connected to one antenna port SRS of the radio-frequency PA Mid device 10 via a radio-frequency transmitting terminal.

The following embodiments are not according to the invention and are present for illustration purposes only. For example, the third switching unit 330 is taken as the radio-frequency SPDT switch to describe the transceiving control of the radio-frequency signal of the radio-frequency L-DRX module 30.

Receiving control: the radio-frequency signal received by the antenna is received via the radio-frequency antenna port ANT. That is, the radio-frequency signal enters the radio-frequency SPDT switch via the radio-frequency antenna port ANT. The radio-frequency SPDT switch is switched to the third filtering unit 320 to switch on the receiving path. The radio-frequency signal is transmitted to the radio-frequency receiving port RXOUT via the second low noise amplifier 310. The radio-frequency receiving port RXOUT outputs the received radio-frequency signal to the radio-frequency transceiver to complete the receiving control of the radio-frequency signal.

Transmitting control: the radio-frequency signal outputted by one antenna port SRS of the radio-frequency PA Mid device 10 is received by the radio-frequency transmitting port SRS. That is, the radio-frequency signal is inputted from the radio-frequency transmitting port SRS to the radio-frequency SPDT switch. The radio-frequency SPDT switch is switched to the radio-frequency antenna port ANT to switch on the transmitting path (also referred to as an SRS path). The radio-frequency signal is radiated out by the first antenna Ant0 via the radio-frequency antenna port ANT. In this way, the transmitting control of the radio-frequency signal is completed.

Further, the LNA device is further integrated with the control unit 180 configured to control the second low noise amplifier 310, to adjust the gain coefficient of the low noise amplifier. Therefore, the receiving power of the radio-frequency signal at the radio-frequency receiving port RXOUT can be adjusted.

As illustrated in FIG. 11B, in an embodiment, the third filtering unit 320 may be disposed at a rear end of the third switching unit 330. That is, the third filtering unit 320 is disposed between the third switching unit 330 and the radio-frequency transmitting port SRS. By disposing the third filtering unit 320 between the third switching unit 330 and the radio-frequency antenna port ANT, a filtering processing can be performed on the radio-frequency signal transmitted in a receiving channel and a transmitting channel, thereby improving an out-of-band rejection capability of the transmitting path. Thus, the transmission performance of both the transmitting path and the receiving path can be balanced.

By integrating the third switching unit 330 and the third filtering unit 320 in the radio-frequency L-DRX module 30, an integration level of the radio-frequency L-DRX module 30 can be increased, and thus resources of the substrate (e.g., a Printed Circuit Board (PCB) board) occupied by the third switching unit 330 and the third filtering unit 320. In addition, by providing the radio-frequency transmitting port SRS on the radio-frequency L-DRX module 30 and connecting the third switching unit 330 to the radio-frequency transmitting port SRS, the radio-frequency L-DRX module 30 can have a function of controlling the transceiving of the radio-frequency signal. In addition, the power supply, logic control, and PCB layout and wiring of the radio-frequency L-DRX device 10 can be simplified, thereby saving the costs.

It should be noted that the radio-frequency L-DRX module 30 according to the embodiments of the present disclosure can support the transceiving control of 5G signals in the N41, N77, N79 frequency bands, etc.

With the development and advancement of technology, 5G mobile communication technology has been increasingly applied to communication apparatuses. A 5G network supports beam-shaping technology, which allows directional transmission to communication apparatuses. In order to realize the directional transmission, a base station first needs to detect a position of a communication apparatus, a quality of a transmitting path, etc., to allocate resources of the base station to each communication apparatus more accurately.

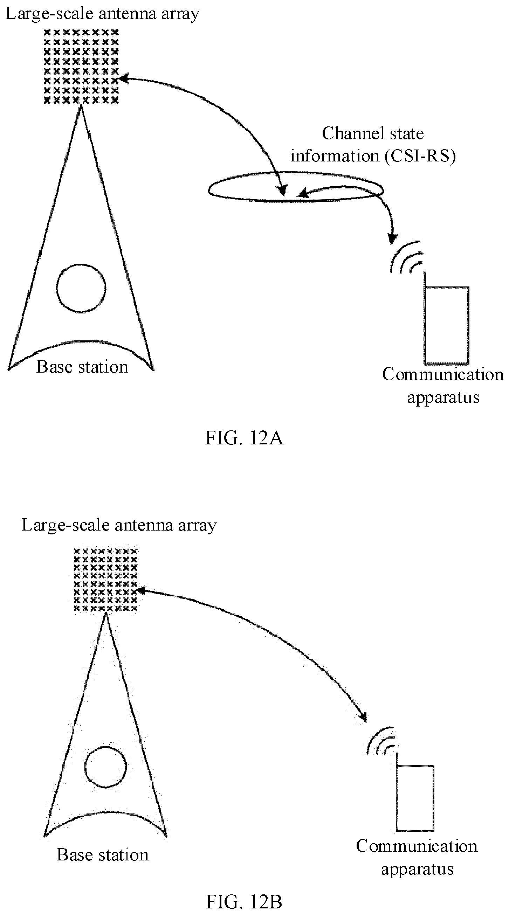

Currently, the communication apparatus provides feedback of channel information in two different modes: Precoding Matrix Indicator (PMI) and Sounding Reference Signal (SRS), signal transmissions of which are as illustrated in FIG. 12A and FIG. 12B, respectively. By standard definition, PMI is a mandatory function for all 5G communication apparatuses, while SRS is an optional function. In PMI, relying on a measurement of a terminal and various quantization algorithms, the base station estimates channel information and resource requirements in accordance with a pre-determined mechanism, and reports the channel information and the resource requirements to the base station. In SRS, the channel information is directly reported to the base station through channel reciprocity. Obviously, SRS is more accurate than PMI.

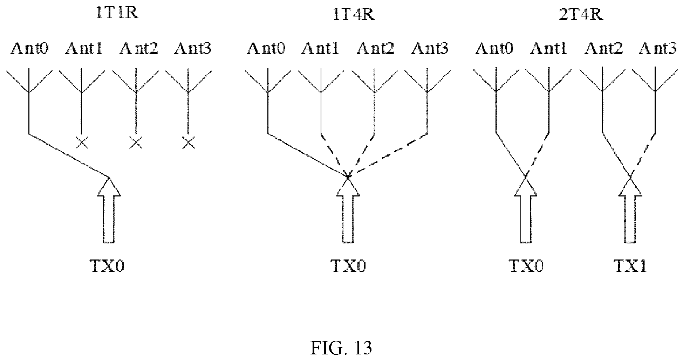

The base station can detect a position of the terminal and a channel quality by transmitting SRS information by the communication apparatus. SRS antenna polling transmission is as illustrated in FIG. 13 and explained in detail below.

1T1R: only feeding back information to the base station at the first antenna Ant0, not supporting the SRS polling transmission.

1T4R: transmitting SRS information in turn at the first antenna Ant0 to a fourth antenna Ant3, where only one antenna is selected for transmission each time. Currently, Non-Standalone (NSA) networks adopt this mode.

2T4R: transmitting SRS information in turn at the first antenna Ant0 to the fourth antenna Ant3, where two antennas are selected for transmission each time. Currently, Standalone (SA) networks adopt this mode.

In an SRS mode, with an increase in the number of antennas that can participate in transmitting a reference signal, the channel estimation can be more accurate, and the corresponding rate can be higher. Under the same number of antennas, an SA mode can complete the channel estimation faster than an NSA mode, improving use experience of a network.

Currently, all major operators have put forward the functional requirements for 5G NR to support SRS. For example, China Mobile has clearly stated in its *White Paper for 5G Terminal Products* that, N41/79 must support SRS function (1T2R or 2T4R); China Unicom has clearly requested in its *White Paper for 5G Terminals* that N78 must support SRS 1T4R and 2T4R antenna polling transmission; and China Telecom proposed in its *Requirements White Paper for 5G All-modes Terminals* that 1-port and 2-port SRS transmission and antenna switching need to be supported and it is recommended to support quad-antenna polling transmission in the n78 frequency band, i.e., SRS 1T4R and 2T4R.

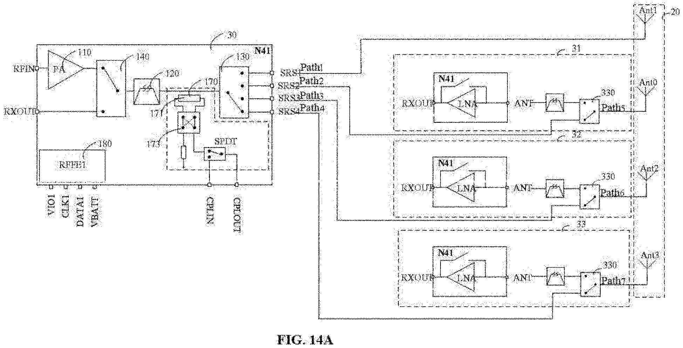

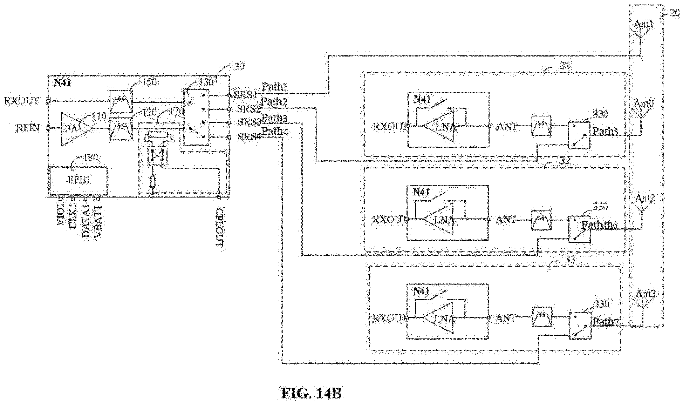

As illustrated in FIG. 14A and FIG. 14B, in an embodiment, the antenna group 20 includes the first antenna Ant0, the second antenna Ant1, a third antenna Ant2, and the fourth antenna Ant3, and three radio-frequency L-DRX modules 30 are provided. The three radio-frequency L-DRX modules 30 are defined as a first radio-frequency L-DRX module 31, a second radio-frequency L-DRX module 32, and a third radio-frequency L-DRX module 33, respectively. The first radio-frequency L-DRX module 31, the second radio-frequency L-DRX module 32, and the third radio-frequency L-DRX module 33 are the same.

The radio-frequency PA Mid device 10 has a first antenna port SRS1, a second antenna port SRS2, a third antenna port SRS3, and a fourth antenna port SRS4. One second terminal of the multi-channel selection switch 130 is one second terminal connected to the second antenna Ant1 via the first antenna port SRS1. Another second terminal of the multi-channel selection switch 130 is connected to the first antenna Ant0 via the second antenna port SRS2 and a polling transmitting port SRS of the first radio-frequency L-DRX module 31. Yet another second terminal of the multi-channel selection switch 130 is connected to the third antenna Ant 2 via the third antenna port SRS3 and a polling transmitting port of the second radio-frequency L-DRX module 32. Still yet another second terminal of the multi-channel selection switch 130 is connected to the fourth antenna Ant3 via the fourth antenna port SRS4 and a polling transmitting port SRS of the third radio-frequency L-DRX module 33. In this way, a 1T4R SRS function can be supported.

The radio-frequency system according to this embodiment can support the quad-antenna 1T4R SRS function. For example, operation principles of SRS in the N41 frequency band are analyzed by taking FIG. 14B as an example.

The radio-frequency signal is transmitted to the first switching unit 140 via the transmitting port RFIN and the power amplifier 110 of the radio-frequency PA Mid device 10, and the radio-frequency signal is switched to the first filtering unit 120 via the first switching unit 140. The radio-frequency signal is further transmitted to the radio-frequency SP4T switch via the first filtering unit 120 and the coupling unit 170. In one case, the radio-frequency SP4T switch is switched to the antenna port SRS1, and the radio-frequency signal is outputted from the second antenna Ant1 via path 1. In another case, the radio-frequency SP4T switch is switched to the antenna port SRS2, and the radio-frequency signal is outputted from the first antenna Ant0 by switching to path 5 via the third switching unit 330 of the first radio-frequency L-DRX module 31.

In yet another case, the radio-frequency SP4T switch is switched to the antenna port SRS3, and the radio-frequency signal is outputted from the third antenna Ant2 by switching to path 6 via the third switching unit 330 of the second radio-frequency L-DRX module 32.

In still yet another case, the radio-frequency SP4T switch is switched to the antenna port SRS4, and the radio-frequency signal is outputted from the fourth antenna Ant3 by switching to path 7 via the third switching unit 330 of the third radio-frequency L-DRX module 31.

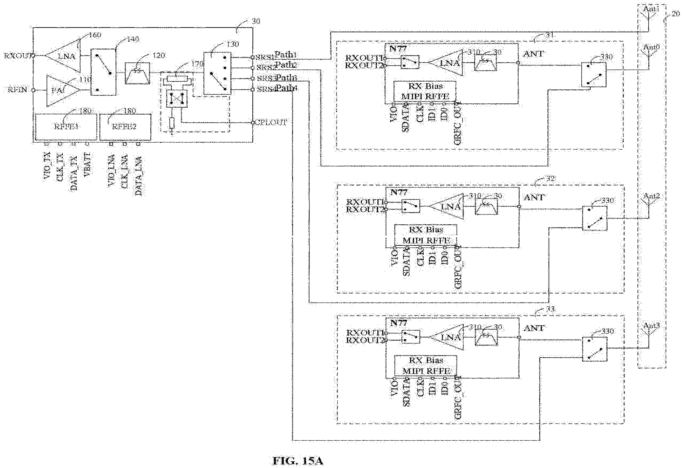

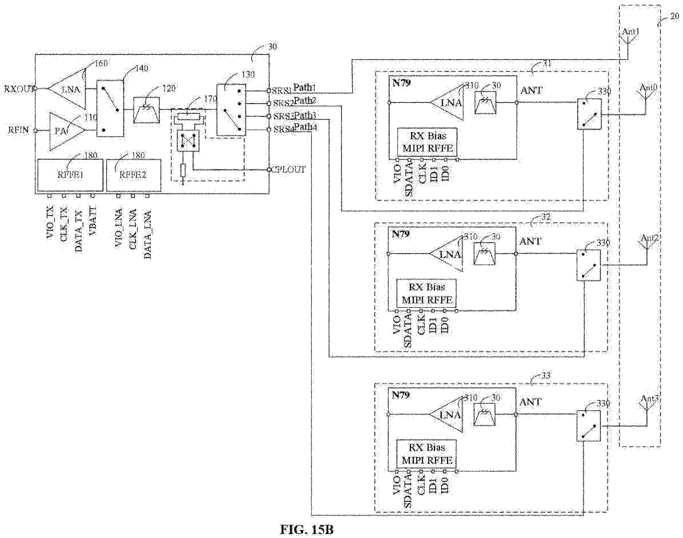

FIG. 15A and FIG. 15B illustrate structural block diagrams of the radio-frequency system for the N77 and N79 frequency bands. Operating principles for SRS in the N77 and N79 frequency bands are similar as those in the N41 frequency band, which is not described in detail herein. Specific path configurations for 1T4R SRS are shown in Table 1.

**[Table 1] Detailed path configurations for 1T4R SRS**

| | N41 | N77 | N79 |
|---|---|---|---|
| Channel 0 | Path 1 | Path 1 | Path 1 |
| Channel 1 | Path 2->Path 5 | Path 2->Path 5 | Path 2->Path 5 |
| Channel 2 | Path 3->Path 6 | Path 3->Path 6 | Path 3->Path 6 |
| Channel 3 | Path 4->Path 7 | Path 4->Path 7 | Path 4->Path 7 |

In Table 1, Channel 0, Channel 1, Channel 2, and Channel 3 are transmitting paths for polling transmission of the antennas.

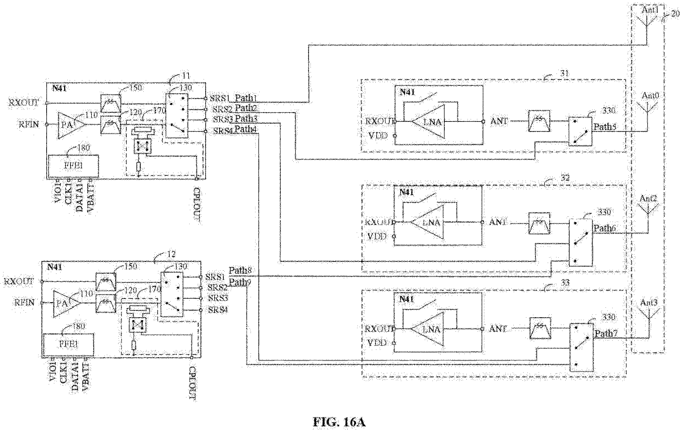

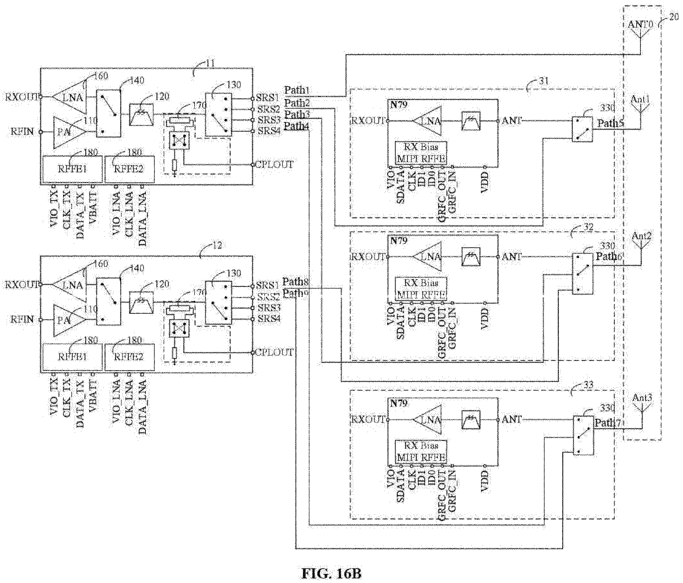

As illustrated in FIG. 16A and FIG. 16B, in an embodiment, the antenna group 20 includes a first antenna Ant0, a second antenna Ant1, a third antenna Ant2, and a fourth antenna Ant3. In addition, two radio-frequency PA Mid devices 10 are provided and defined as a first radio-frequency PA Mid device 11 and a second radio-frequency PA Mid device 12, respectively. The first radio-frequency PA Mid device 11 and the second radio-frequency PA Mid device 12 have each a first antenna port SRS1, a second antenna port SRS2, a third antenna port SRS3, and a fourth antenna port SRS4. In addition, three radio-frequency L-DRX modules 30 are provided and defined as a first radio-frequency L-DRX module 31, a second radio-frequency L-DRX module 32, and a third radio-frequency L-DRX module 33, respectively.

In the first radio-frequency PA Mid device 11, one second terminal of the multi-channel selection switch 130 is connected to the second antenna Ant1 via the first antenna port SRS1; another second terminal of the multi-channel selection switch 130 is connected to the first antenna Ant0 via the second antenna port SRS2 and the third switching unit 330 of the first radio-frequency L-DRX module 31; yet another second terminal of the multi-channel selection switch 130 is connected to the third antenna Ant2 via the third antenna port SRS3 and the third switching unit 330 of the second radio-frequency L-DRX module 32; and still yet another second terminal of the multi-channel selection switch 130 is connected to the fourth antenna Ant3 via the fourth antenna port SRS4 and the third switching unit 330 of the third radio-frequency L-DRX module 33. In the second radio-frequency PA Mid device 12, one second terminal of the multi-channel selection switch 130 is connected to the third antenna Ant2 via the third switching unit 330 of the second radio-frequency L-DRX module 32, and another second terminal of the multi-channel selection switch 130 is connected to the fourth antenna Ant3 via the third switching unit 330 of the third radio-frequency L-DRX module 33, to support a 2T4R SRS function.

The radio-frequency system according to this embodiment can support the quad-antenna 2T4R SRS function. Specific path configurations for 2T4R SRS are shown in Table 2.

**[Table 2] Detailed path configurations for 2T4R SRS**

| | N41 | N77 | N79 |
|---|---|---|---|
| Channel 0 | Path 1 | Path 1 | Path 1 |
| Channel 1 | Path 2->path 5 | Path 2->path 5 | Path 2->path 5 |
| Channel 2 | Path 8->Path 6 | Path 8->Path 6 | Path 8->Path 6 |
| Channel 3 | Path 9->Path 7 | Path 9->Path 7 | Path 9->Path 7 |

In Table 2, Channel 0, Channel 1, Channel 2, and Channel 3 are transmitting paths for polling transmission of the antennas.

The radio-frequency system according to the above embodiments can support the 1T4R SRS function or the 2T4R SRS function. In addition, with the radio-frequency system, by packaging the radio-frequency L-DRX module 30, the radio-frequency PA Mid device 10, the polling transmission of the radio-frequency signal at the first antenna Ant0, the second antenna Ant1, the third antenna Ant2, and the fourth antenna Ant3 can be realized without providing a plurality of independent cascade switches. In this way, the costs can be lowered, and an area of the substrate occupied by different components in the radio-frequency system can be reduced.

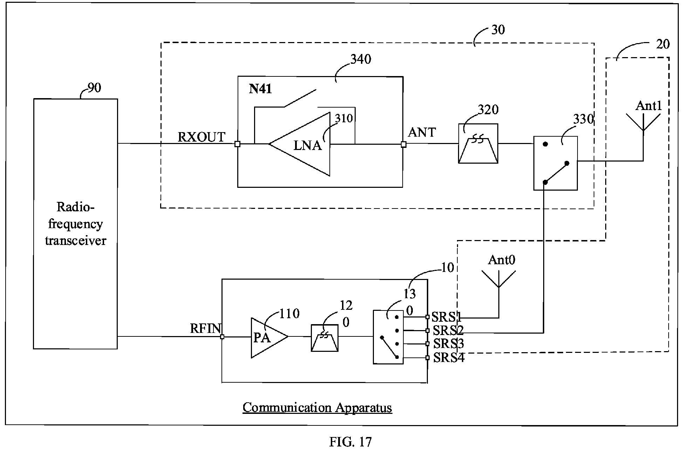

As illustrated in FIG. 17, according to an embodiment of the present disclosure, a communication apparatus is further provided. The communication apparatus includes the radio-frequency transceiving system according to any of the above embodiments and a radio-frequency transceiver 90, which are disposed therein. For example, the radio-frequency transceiver 90 may include a transmitter (e.g., transmitter TX) and a receiver (e.g., receiver RX); or the radio-frequency transceiver 90 may include the receiver (e.g., receiver RX) only; or the radio-frequency transceiver 90 may include the transmitter (e.g., transmitter TX) only. The radio-frequency transceiver 90 can be configured to implement a frequency conversion processing between an intermediate frequency signal and a baseband signal and/or to implement a frequency conversion processing between an intermediate frequency signal and a high frequency signal, or the like.

By providing the radio-frequency transceiving system in the communication apparatus, the integration level of the radio-frequency transceiving system can be increased, and the area of the substrate occupied by different components in the radio-frequency transceiving system can be reduced. In addition, the power supply, logic control, and PCB layout and wiring of the radio-frequency L-DRX module 30 and the radio-frequency PA Mid device 10 can be simplified, thereby saving the costs.

While several embodiments of the present disclosure have been described above in a specific and detailed manner, the protection scope of the present disclosure cannot be construed as being limited to these embodiments. It should be noted that, those skilled in the art can make various variants and improvements without departing from the concept of the present disclosure, and these variants and improvements shall fall within the protection scope of present disclosure as defined by the claims as attached.

## Claims

1. A radio-frequency Power Amplifier Modules including Duplexers (PA Mid) device (10), having a transmitting port configured to connect to a radio-frequency transceiver (90), a receiving port configured to connect to the radio-frequency transceiver (90) and four antenna ports each configured to connect to an antenna, the radio-frequency PA Mid device (10) comprising:
a power amplifier (110) having an input terminal connected to the transmitting port, the power amplifier (110) being configured to perform a power amplification processing on a received radio-frequency signal;
a first filtering unit (120) connected to an output terminal of the power amplifier (110), the first filtering unit (120) being configured to perform a filtering processing on the received radio-frequency signal;
a second filtering unit (150) connected to the receiving port, the second filtering unit (150) being configured to perform a filtering processing on the radio-frequency signal received by the four antenna ports; and
a multi-channel selection switch (130) being a radio-frequency Double-Pole Four-Throw (DP4T) switch having two first terminals and four second terminals, one of the two first terminals being connected to the first filtering unit (120), the other one of the two first terminals being connected to the second filtering unit (150), and the four second terminals being connected to the four antenna ports in a one-to-one correspondence, wherein the multi-channel selection switch (130) is configured to selectively switch on a transmitting path between the transmitting port and any one of the four antenna ports for transmission of the radio-frequency signal and supporting a function of polling transmission of a Sounding Reference Signal (SRS) among the four antenna ports.

2. The radio-frequency PA Mid device (10) according to claim 1, further comprising:
a first low noise amplifier (160) disposed in the receiving path, wherein the first low noise amplifier (160) is configured to amplify the radio-frequency signal received by the plurality of antenna ports and output the radio-frequency signal via the receiving port.

3. The radio-frequency PA Mid device (10) according to claim 1, further having a coupling output port, wherein the radio-frequency PA Mid device (10) further comprises:
a coupling circuit (170) coupled to the first filtering unit (120) and the at least one first terminal of the multi-channel selection switch (130), and connected to the coupling output port, wherein the coupling circuit (170) is configured to couple the radio-frequency signal to output a coupling signal for measuring power information.

4. The radio-frequency PA Mid device (10) according to claim 3, wherein the coupling signal comprises a forward coupling signal and a reverse coupling signal; and
wherein the coupled circuit comprises:
a coupling unit (171) having an input terminal coupled to the first filtering unit (120), an output terminal coupled to the at least one first terminal of the multi-channel selection switch (130), a first coupling terminal, and a second coupling terminal; and
a coupling switch (173) connected to the first coupling terminal, the second coupling terminal, and the coupling output port, the coupling switch (173) being configured to selectively output the forward coupling signal or the reverse coupling signal.

5. The radio-frequency PA Mid device (10) according to claim 1, wherein the radio-frequency signal is a 5G signal in an N41 frequency band, an N77 frequency band, or an N79 frequency band.

6. A radio-frequency transceiving system, comprising:
an antenna group (20) comprising a first antenna, a second antenna, a third antenna, and a fourth antenna, the antenna group (20) being configured to transmit and receive a radio-frequency signal;
three radio-frequency L-DRX modules (30) being provided as a first radio-frequency L-DRX module (31), a second radio-frequency L-DRX module (32), and a third radio-frequency L-DRX module (33), respectively; and
at least one radio-frequency PA Mid device (10) according to any one of claims 1 to 6, the four antenna ports of the at least one radio-frequency PA Mid device (10) comprising a first antenna port connected to the second antenna, a second antenna port connected to the first antenna via the first radio-frequency L-DRX module (31), a third antenna port connected to the third antenna via the second radio-frequency L-DRX module (32), and a fourth antenna port connected to the fourth antenna via the third radio-frequency L-DRX module (33); wherein the radio-frequency PA Mid device (10) is configured to support a function of polling transmission of SRS between the first antenna, the second antenna, the third antenna, and the fourth antenna.

7. The radio-frequency transceiving system according to claim 6, wherein each of the radio-frequency L-DRX modules (30) comprises:
a third switching unit (330) connected to the first antenna and one of the plurality of antenna ports of the radio-frequency PA Mid device (10);
a third filtering unit (320) connected to the third switching unit (330) and configured to perform a filtering processing on the radio-frequency signal received by the first antenna; and
a second low noise amplifier (310) having an input terminal connected to the third filtering unit (320) and an output terminal, the second low noise amplifier (310) being configured to amplify the received radio-frequency signal and output, via the output terminal of second low noise amplifier (310), the amplified radio-frequency signal to the radio-frequency transceiver (90),
wherein the third switching unit (330) is configured to selectively switch on a receiving path where the second low noise amplifier (310) is located and a transmitting path where the radio-frequency PA Mid device (10) is located.

8. The radio-frequency transceiving system according to claim 7, wherein the radio-frequency L-DRX module (30) further comprises:
a bypass switch (340) connected in parallel with the second low noise amplifier (310), and
preferably, the second low noise amplifier (310) and the bypass switch (340) are packaged in a same chip.

9. The radio-frequency transceiving system according to claim 7, wherein the second low noise amplifier (310) and the third filtering unit (320) are packaged in a same chip; or
wherein the second low noise amplifier (310), the third filtering unit (320), and the third switching unit (330) are packaged in a same chip.

10. The radio-frequency transceiving system according to claim 6, wherein:
the at least one radio-frequency PA Mid device (10) comprises a first radio-frequency PA Mid device (11) and a second radio-frequency PA Mid device (12), respectively;
the plurality of antenna ports of each of the first radio-frequency PA Mid device (11) and the second radio-frequency PA Mid device (12) comprises the first antenna port, the second antenna port, the third antenna port, and the fourth antenna port;
the first antenna port of the first radio-frequency PA Mid device (11) is connected to the second antenna; the second antenna port of the first radio-frequency PA Mid device (11) is connected to the first antenna via the first radio-frequency L-DRX module (31); the third antenna port of the first radio-frequency PA Mid device (11) is connected to the third antenna via the second radio-frequency L-DRX module (32); and the fourth antenna port of the first radio-frequency PA Mid device (11) is connected to the fourth antenna via the third radio-frequency L-DRX module (33); and
the first antenna port of the second radio-frequency PA Mid device (12) is connected to the third antenna via the second radio-frequency L-DRX module (32); and the second antenna port of the second radio-frequency PA Mid device (12) is connected to the fourth antenna via the third radio-frequency L-DRX module (33).

11. A communication apparatus, comprising:
a radio-frequency transceiver (90); and
the radio-frequency transceiving system according to any one of claims 6 to 10, the radio-frequency transceiving system being connected to the radio-frequency transceiver (90).

## Patentansprüche

1. Funkfrequenz-Leistungsverstärkermoduleeinschließlich-Duplexer(PA Mid)-Vorrichtung (10), mit einem Sendeport, der konfiguriert ist, mit einem Funkfrequenzsendeempfänger (90) verbunden zu sein, einem Empfangsport, der konfiguriert ist, mit dem Funkfrequenzsendeempfänger (90) verbunden zu sein, und vier Antennenports, die jeweils konfiguriert sind, mit einer Antenne verbunden zu sein, wobei die Funkfrequenz-PA-Mid-Vorrichtung (10) umfasst:
einen Leistungsverstärker (110) mit einem Eingangsanschluss, der mit dem Sendeport verbunden ist,
wobei der Leistungsverstärker (110) konfiguriert ist, eine Leistungsverstärkungsverarbeitung an einem empfangenen Funkfrequenzsignal durchzuführen;
eine erste Filtereinheit (120), die mit einem Ausgangsanschluss des Leistungsverstärkers (110) verbunden ist, wobei die erste Filtereinheit (120) konfiguriert ist, eine Filterverarbeitung an dem empfangenen Funkfrequenzsignal durchzuführen;
eine zweite Filtereinheit (150), die mit dem Empfangsport verbunden ist, wobei die zweite Filtereinheit (150) konfiguriert ist, eine Filterverarbeitung an dem durch die vier Antennenports empfangenen Funkfrequenzsignal durchzuführen; und
einen Mehrkanalauswahlschalter (130), der ein zweipoliger Funkfrequenz-Vierwege-Schalter (Funkfrequenz-DP4T-Schalter) mit zwei ersten Anschlüssen und vier zweiten Anschlüssen ist, wobei einer der beiden ersten Anschlüsse mit der ersten Filtereinheit (120) verbunden ist, der andere der beiden ersten Anschlüsse mit der zweiten Filtereinheit (150) verbunden ist, und die vier zweiten Anschlüsse mit den vier Antennenports in einer Eins-zu-Eins-Korrespondenz verbunden sind, wobei der Mehrkanalauswahlschalter (130) konfiguriert ist, einen Sendepfad zwischen dem Sendeport und einem beliebigen der vier Antennenports zur Übertragung des Funkfrequenzsignals und Unterstützung einer Abfrageübertragungsfunktion eines Sondierungsreferenzsignals (SRS) unter den vier Antennenports selektiv einzuschalten.

2. Funkfrequenz-PA-Mid-Vorrichtung (10) nach Anspruch 1, ferner umfassend:
einen ersten rauscharmen Verstärker (160), der im Empfangspfad angeordnet ist, wobei der erste rauscharme Verstärker (160) konfiguriert ist, das durch die mehreren Antennenports empfangene Funkfrequenzsignal zu verstärken und das Funkfrequenzsignal über den Empfangsport auszugeben.

3. Funkfrequenz-PA-Mid-Vorrichtung (10) nach Anspruch 1, ferner aufweisend einen Koppelausgangsport, wobei die Funkfrequenz-PA-Mid-Vorrichtung (10) ferner umfasst:
eine Koppelschaltung (170), die mit der ersten Filtereinheit (120) und dem mindestens einen ersten Anschluss des Mehrkanalauswahlschalters (130) gekoppelt ist und mit dem Koppelausgangsport verbunden ist, wobei die Koppelschaltung (170) konfiguriert ist, das Funkfrequenzsignal zu koppeln, um ein Koppelsignal zum Messen von Leistungsinformationen auszugeben.

4. Funkfrequenz-PA-Mid-Vorrichtung (10) nach Anspruch 3, wobei das Koppelsignal ein Vorwärtskoppelsignal und ein Rückwärtskoppelsignal umfasst; und
wobei die gekoppelte Schaltung umfasst:
eine Koppeleinheit (171) mit einem Eingangsanschluss, der mit der ersten Filtereinheit (120) gekoppelt ist, einem Ausgangsanschluss, der mit dem mindestens einen ersten Anschluss des Mehrkanalauswahlschalters (130) gekoppelt ist, einem ersten Koppelanschluss und einem zweiten Koppelanschluss; und
einen Koppelschalter (173), der mit dem ersten Koppelanschluss, dem zweiten Koppelanschluss und dem Koppelausgangsport verbunden ist, wobei der Koppelschalter (173) konfiguriert ist, selektiv das Vorwärtskoppelsignal oder das Rückwärtskoppelsignal auszugeben.

5. Funkfrequenz-PA-Mid-Vorrichtung (10) nach Anspruch 1, wobei das Funkfrequenzsignal ein 5G-Signal in einem N41-Frequenzband, einem N77-Frequenzband oder einem N79-Frequenzband ist.

6. Funkfrequenz-Sendeempfangssystem, umfassend:
eine Antennengruppe (20), die eine erste Antenne, eine zweite Antenne, eine dritte Antenne und eine vierte Antenne umfasst, wobei die Antennengruppe (20) konfiguriert ist, ein Funkfrequenzsignal zu senden und zu empfangen;
drei Funkfrequenz-L-DRX-Module (30), die als ein erstes Funkfrequenz-L-DRX-Modul (31), ein zweites Funkfrequenz-L-DRX-Modul (32) bzw. ein drittes Funkfrequenz-L-DRX-Modul (33) bereitgestellt sind; und
mindestens eine Funkfrequenz-PA-Mid-Vorrichtung (10) nach einem der Ansprüche 1 bis 6, wobei die vier Antennenports der mindestens einen Funkfrequenz-PA-Mid-Vorrichtung (10) einen ersten Antennenport, der mit der zweiten Antenne verbunden ist, einen zweiten Antennenport, der über das erste Funkfrequenz-L-DRX-Modul (31) mit der ersten Antenne verbunden ist, einen dritten Antennenport, der über das zweite Funkfrequenz-L-DRX-Modul (32) mit der dritten Antenne verbunden ist,
und einen vierten Antennenport, der über das dritte Funkfrequenz-L-DRX-Modul (33) mit der vierten Antenne verbunden ist, umfassen; wobei die Funkfrequenz-PA-Mid-Vorrichtung (10) konfiguriert ist, eine Abfrageübertragungsfunktion eines SRS zwischen der ersten Antenne, der zweiten Antenne, der dritten Antenne und der vierten Antenne zu unterstützen.

7. Funkfrequenz-Sendeempfangssystem nach Anspruch 6, wobei jedes der Funkfrequenz-L-DRX-Module (30) umfasst:
eine dritte Schalteinheit (330), die mit der ersten Antenne und einem der mehreren Antennenports der Funkfrequenz-PA-Mid-Vorrichtung (10) verbunden ist;
eine dritte Filtereinheit (320), die mit der dritten Schalteinheit (330) verbunden ist und konfiguriert ist,
eine Filterverarbeitung an dem durch die erste Antenne empfangenen Funkfrequenzsignal durchzuführen; und
einen zweiten rauscharmen Verstärker (310) mit einem Eingangsanschluss, der mit der dritten Filtereinheit (320) verbunden ist, und einem Ausgangsanschluss, wobei der zweite rauscharme Verstärker (310) konfiguriert ist, das empfangene Funkfrequenzsignal zu verstärken und das verstärkte Funkfrequenzsignal über den Ausgangsanschluss des zweiten rauscharmen Verstärkers (310) an den Funkfrequenz-Sendeempfänger (90) auszugeben,
wobei die dritte Schalteinheit (330) konfiguriert ist, einen Empfangspfad, in dem sich der zweite rauscharme Verstärker (310) befindet, und einen Sendepfad, in dem sich die Funkfrequenz-PA-Mid-Vorrichtung (10) befindet, selektiv einzuschalten.

8. Funkfrequenz-Sendeempfangssystem nach Anspruch 7, wobei das Funkfrequenz-L-DRX-Modul (30) ferner umfasst:
einen Bypass-Schalter (340), der parallel mit dem zweiten rauscharmen Verstärker (310) verbunden ist, und
wobei vorzugsweise der zweite rauscharme Verstärker (310) und der Bypass-Schalter (340) auf einem selben Chip gekapselt sind.

9. Funkfrequenz-Sendeempfangssystem nach Anspruch 7, wobei der zweite rauscharme Verstärker (310) und die dritte Filtereinheit (320) in einem selben Chip gekapselt sind; oder
wobei der zweite rauscharme Verstärker (310), die dritte Filtereinheit (320) und die dritte Schalteinheit (330) in einem selben Chip gekapselt sind.

10. Funkfrequenz-Sendeempfangssystem nach Anspruch 6, wobei:
die mindestens eine Funkfrequenz-PA-Mid-Vorrichtung (10) eine erste Funkfrequenz-PA-Mid-Vorrichtung (11) bzw. eine zweite Funkfrequenz-PA-Mid-Vorrichtung (12) umfasst;
die mehreren Antennenports sowohl der ersten Funkfrequenz-PA-Mid-Vorrichtung (11) als auch der zweiten Funkfrequenz-PA-Mid-Vorrichtung (12) den ersten Antennenport, den zweiten Antennenport, den dritten Antennenport und den vierten Antennenport umfassen;
der erste Antennenport der ersten Funkfrequenz-PA-Mid-Vorrichtung (11) mit der zweiten Antenne verbunden ist; der zweite Antennenport der ersten Funkfrequenz-PA-Mid-Vorrichtung (11) über das erste Funkfrequenz-L-DRX-Modul (31) mit der ersten Antenne verbunden ist; der dritte Antennenport der ersten Funkfrequenz-PA-Mid-Vorrichtung (11) über das zweite Funkfrequenz-L-DRX-Modul (32) mit der dritten Antenne verbunden ist; und der vierte Antennenport der ersten Funkfrequenz-PA-Mid-Vorrichtung (11) über das dritte Funkfrequenz-L-DRX-Modul (33) mit der vierten Antenne verbunden ist; und
der erste Antennenport der zweiten Funkfrequenz-PA-Mid-Vorrichtung (12) über das zweite Funkfrequenz-L-DRX-Modul (32) mit der dritten Antenne verbunden ist; und der zweite Antennenport der zweiten Funkfrequenz-PA-Mid-Vorrichtung (12) über das dritte Funkfrequenz-L-DRX-Modul (33) mit der vierten Antenne verbunden ist.

11. Kommunikationseinrichtung, umfassend:
einen Funkfrequenz-Sendeempfänger (90); und
das Funkfrequenz-Sendeempfangssystem nach einem der Ansprüche 6 bis 10, wobei das Funkfrequenz-Sendeempfangssystem mit dem Funkfrequenz-Sendeempfänger (90) verbunden ist.

## Revendications

1. Dispositif à modules amplificateurs de puissance incluant des duplexeurs, Power Amplifier Modules including Duplexers PA Mid, (10) à radiofréquence, ayant un port de transmission configuré pour se connecter à un transmetteur-récepteur de radiofréquence (90), un port de réception configuré pour se connecter au transmetteur-récepteur de radiofréquence (90) et quatre ports d'antenne, chacun configuré pour se connecter à une antenne, le dispositif PA Mid (10) à radiofréquence comprenant :
un amplificateur de puissance (110) ayant une borne d'entrée connectée au port de transmission, l'amplificateur de puissance (110) étant configuré pour réaliser un traitement d'amplification de puissance sur un signal de radiofréquence reçu ;
une première unité de filtrage (120) connectée à une borne de sortie de l'amplificateur de puissance (110), la première unité de filtrage (120) étant configurée pour réaliser un traitement de filtrage sur le signal de radiofréquence reçu ;
une deuxième unité de filtrage (150) connectée au port de réception, la deuxième unité de filtrage (150) étant configurée pour réaliser un traitement de filtrage sur le signal de radiofréquence reçu par les quatre ports d'antenne ; et
un commutateur de sélection multicanal (130), qui est un commutateur radiofréquence bipolaire à quatre directions, Double-Pole Four-Throw DP4T, ayant deux premières bornes et quatre secondes bornes, une des deux premières bornes étant connectée à la première unité de filtrage (120), l'autre des deux premières bornes étant connectée à la deuxième unité de filtrage (150), et les quatre secondes bornes étant connectées aux quatre ports d'antenne dans une correspondance une-à-une, dans lequel le commutateur de sélection multicanal (130) est configuré pour mettre sélectivement en service un chemin de transmission entre le port de transmission et l'un quelconque des quatre ports d'antenne pour la transmission du signal de radiofréquence et pour prendre en charge une fonction de transmission d'interrogation d'un signal de référence de sondage, Sounding Reference Signal SRS, parmi les quatre ports d'antenne.

2. Dispositif PA Mid (10) à radiofréquence selon la revendication 1, comprenant en outre :
un premier amplificateur à faible bruit (160) disposé dans le chemin de réception, dans lequel le premier amplificateur à faible bruit (160) est configuré pour amplifier le signal de radiofréquence reçu par la pluralité de ports d'antenne et produire en sortie le signal de radiofréquence par l'intermédiaire du port de réception.

3. Dispositif PA Mid (10) à radiofréquence selon la revendication 1, ayant en outre un port de sortie de couplage, dans lequel le dispositif PA Mid (10) à radiofréquence comprend en outre :
un circuit de couplage (170) couplé à la première unité de filtrage (120) et à l'au moins une première borne du commutateur de sélection multicanal (130), et connecté au port de sortie de couplage, dans lequel le circuit de couplage (170) est configuré pour coupler le signal de radiofréquence pour produire en sortie un signal de couplage pour mesurer des informations de puissance.

4. Dispositif PA Mid (10) à radiofréquence selon la revendication 3, dans lequel le signal de couplage comprend un signal de couplage vers l'avant et un signal de couplage vers l'arrière ; et
dans lequel le circuit couplé comprend :
une unité de couplage (171) ayant une borne d'entrée couplée à la première unité de filtrage (120), une borne de sortie couplée à l'au moins une première borne du commutateur de sélection multicanal (130), une première borne de couplage, et une seconde borne de couplage ; et
un commutateur de couplage (173) connecté à la première borne de couplage, à la seconde borne de couplage, et au port de sortie de couplage, le commutateur de couplage (173) étant configuré pour produire sélectivement en sortie le signal de couplage vers l'avant ou le signal de couplage vers l'arrière.

5. Dispositif PA Mid (10) à radiofréquence selon la revendication 1, dans lequel le signal de radiofréquence est un signal 5G dans une bande de fréquence N41, une bande de fréquence N77, ou une bande de fréquence N79.

6. Système de transmission-réception de radiofréquence, comprenant :
un groupe d'antennes (20) comprenant une première antenne, une deuxième antenne, une troisième antenne, et une quatrième antenne, le groupe d'antennes (20) étant configuré pour transmettre et recevoir un signal de radiofréquence ;
trois modules L-DRX (30) à radiofréquence prévus sous la forme d'un premier module L-DRX (31) à radiofréquence, d'un deuxième module L-DRX (32) à radiofréquence, et d'un troisième module L-DRX (33) à radiofréquence, respectivement ; et
au moins un dispositif PA Mid (10) à radiofréquence selon l'une quelconque des revendications 1 à 6, les quatre ports d'antenne de l'au moins un dispositif PA Mid (10) à radiofréquence comprenant un premier port d'antenne connecté à la deuxième antenne, un deuxième port d'antenne connecté à la première antenne par l'intermédiaire du premier module L-DRX (31) à radiofréquence, un troisième port d'antenne connecté à la troisième antenne par l'intermédiaire du deuxième module L-DRX (32) à radiofréquence, et un quatrième port d'antenne connecté à la quatrième antenne par l'intermédiaire du troisième module L-DRX (33) à radiofréquence ; dans lequel le dispositif PA Mid (10) à radiofréquence est configuré pour prendre en charge une fonction de transmission d'interrogation de SRS entre la première antenne, la deuxième antenne, la troisième antenne, et la quatrième antenne.

7. Système de transmission-réception de radiofréquence selon la revendication 6, dans lequel chacun des modules L-DRX (30) à radiofréquence comprend :
une troisième unité de commutation (330) connectée à la première antenne et à un port parmi la pluralité de ports d'antenne du dispositif PA Mid (10) à radiofréquence ;
une troisième unité de filtrage (320) connectée à la troisième unité de commutation (330) et configurée pour réaliser un traitement de filtrage sur le signal de radiofréquence reçu par la première antenne ; et
un second amplificateur à faible bruit (310) ayant une borne d'entrée connectée à la troisième unité de filtrage (320) et une borne de sortie, le second amplificateur à faible bruit (310) étant configuré pour amplifier le signal de radiofréquence reçu et envoyer en sortie, par l'intermédiaire de la borne de sortie du second amplificateur à faible bruit (310), le signal de radiofréquence amplifié au transmetteur-récepteur de radiofréquence (90),
dans lequel la troisième unité de commutation (330) est configurée pour mettre sélectivement en service un chemin de réception où est situé le second amplificateur à faible bruit (310) et un chemin de transmission où est situé le dispositif PA Mid (10) à radiofréquence.

8. Système de transmission-réception de radiofréquence selon la revendication 7, dans lequel le module L-DRX à radiofréquence (30) comprend en outre :
un commutateur de dérivation (340) connecté en parallèle au second amplificateur à faible bruit (310), et de préférence, le second amplificateur à faible bruit (310) et le commutateur de dérivation (340) sont encapsulés dans une même puce.

9. Système de transmission-réception de radiofréquence selon la revendication 7, dans lequel le second amplificateur à faible bruit (310) et la troisième unité de filtrage (320) sont encapsulés dans une même puce ; ou
dans lequel le second amplificateur à faible bruit (310), la troisième unité de filtrage (320), et la troisième unité de commutation (330) sont encapsulés dans une même puce.

10. Système de transmission-réception de radiofréquence selon la revendication 6, dans lequel :
l'au moins un dispositif PA Mid (10) à radiofréquence comprend un premier dispositif PA Mid (11) à radiofréquence et un second dispositif PA Mid (12) à radiofréquence, respectivement ;
la pluralité de ports d'antenne de chacun du premier dispositif PA Mid (11) à radiofréquence et du second dispositif PA Mid (12) à radiofréquence comprend le premier port d'antenne, le deuxième port d'antenne, le troisième port d'antenne, et le quatrième port d'antenne ;
le premier port d'antenne du premier dispositif PA Mid (11) à radiofréquence est connecté à la deuxième antenne ; le deuxième port d'antenne du premier dispositif PA Mid (11) à radiofréquence est connecté à la première antenne par l'intermédiaire du premier module L-DRX (31) à radiofréquence ; le troisième port d'antenne du premier dispositif PA Mid (11) à radiofréquence est connecté à la troisième antenne par l'intermédiaire du deuxième module L-DRX (32) à radiofréquence ; et le quatrième port d'antenne du premier dispositif PA Mid (11) à radiofréquence est connecté à la quatrième antenne par l'intermédiaire du troisième module L-DRX (33) à radiofréquence ; et
le premier port d'antenne du second dispositif PA Mid (12) à radiofréquence est connecté à la troisième antenne par l'intermédiaire du deuxième module L-DRX (32) à radiofréquence ; et le deuxième port d'antenne du second dispositif PA Mid (12) à radiofréquence est connecté à la quatrième antenne par l'intermédiaire du troisième module L-DRX (33) à radiofréquence.

11. Appareil de communication, comprenant :
un transmetteur-récepteur de radiofréquence (90) ; et
le système de transmission-réception de radiofréquence selon l'une quelconque des revendications 6 à 10, le système de transmission-réception de radiofréquence étant connecté au transmetteur-récepteur de radiofréquence (90).
